# EUROPEAN PATENT APPLICATION

(11) **EP 4 498 690 A1**
(43) Date of publication of application: **29.01.2025**
(21) Application number: 23774392.7
(22) Date of filing: 27.02.2023
(51) Int. Cl.: H04N 25/13

(54) **IMAGING DEVICE AND ELECTRONIC APPARATUS**

(30) Priority: 22.03.2022 JP 2022045250
(71) Applicant: Sony Semiconductor Solutions Corporation, Atsugi-shi, Kanagawa 243-0014 (JP)
(72) Inventor: SAKAMOTO, Michiko, Atsugi-shi, Kanagawa 243-0014 (JP)
(74) Representative: MFG Patentanwälte Meyer-Wildhagen Meggle-Freund Gerhard PartG mbB
(86) International application number: PCT/JP2023/007036
(87) International publication number: WO 2023/181793

(57) **Abstract**

There is provided an imaging device (1) including a pixel array unit (30) configured by two-dimensionally arranging unit regions each including a plurality of imaging elements (100), in which each of the imaging elements includes a color filter (54) that has a rectangular shape in plan view and transmits light having a wavelength of a predetermined wavelength band, and a photoelectric conversion unit (12) that generates a charge by light incident through the color filter, and in the unit region, five or more types of the plurality of imaging elements distinguished by a wavelength of light transmitted through the corresponding color filter are arranged in m rows and n columns, and the first imaging element and a fourth imaging element including a fourth color filter having a refractive index lower than that of the first color filter at a wavelength of 510 nm to 550 nm are not arranged so as to be in contact with each other on two or more sides of the first imaging element.

## Description

### Field

The present disclosure relates to an imaging device and an electronic device.

### Background

An imaging device having a plurality of color filters arranged according to a Bayer arrangement has been proposed. However, since there is a limit to improvement in color reproducibility and the like in the imaging device of the Bayer arrangement, in recent years, an imaging device using a color filter that transmits light of a color having complementary color relationships with red, green, and blue included in the Bayer arrangement has been proposed.

### Citation List

### Patent Literature

Patent Literature 1: JP 2019-175912 A

### Summary

### Technical Problem

However, even in the imaging device using the color filter that transmits the light of color having the complementary color relationships as described above, since arrangement of the color filters and a refractive index of the color filter have not been studied, it cannot be said that effects of improving color reproducibility and suppressing noise, which would be obtained by such a configuration, are sufficiently extracted.

Therefore, the present disclosure proposes an imaging device and an electronic device capable of obtaining effects of improving color reproducibility and suppressing noise.

### Solution to Problem

According to the present disclosure, there is provided an imaging device including a pixel array unit configured by two-dimensionally arranging unit regions each including a plurality of imaging elements. In the imaging device, each of the imaging elements includes: a color filter that has a rectangular shape in plan view and transmits light having a wavelength in a predetermined wavelength band; and a photoelectric conversion unit that generates a charge by light incident through the color filter. In the unit region, five or more types of the plurality of imaging elements distinguished by a wavelength of light transmitted through the corresponding color filter are arranged in m rows and n columns, at least a first imaging element including a first color filter that transmits red light, a second imaging element including a second color filter that transmits green light, and a third imaging element including a third color filter that transmits blue light are included. The first imaging element and a fourth imaging element including a fourth color filter having a refractive index lower than a refractive index of the first color filter at a wavelength of 510 nm to 550 nm are not arranged so as to be in contact with each other on two or more sides of the first imaging element.

Furthermore, according to the present disclosure, there is provided an electronic device on which an imaging device is mounted. In the electronic device, the imaging device includes a pixel array unit configured by two-dimensionally arranging unit regions each including a plurality of imaging elements, each of the imaging elements includes: a color filter that has a rectangular shape in plan view and transmits light having a wavelength in a predetermined wavelength band; and a photoelectric conversion unit that generates a charge by light incident through the color filter. In the unit region, five or more types of the plurality of imaging elements distinguished by a wavelength of light transmitted through the corresponding color filter are arranged in m rows and n columns, at least a first imaging element including a first color filter that transmits red light, a second imaging element including a second color filter that transmits green light, and a third imaging element including a third color filter that transmits blue light are included. The first imaging element and a fourth imaging element including a fourth color filter having a refractive index lower than a refractive index of the first color filter at a wavelength of 510 nm to 550 nm are not arranged so as to be in contact with each other on two or more sides of the first imaging element.

### Brief Description of Drawings

FIG. 1 is an explanatory diagram illustrating a planar configuration example of an imaging device 1 according to embodiments of the present disclosure.
FIG. 2 is an explanatory diagram illustrating a part of a cross section of an imaging element 100 according to the embodiments of the present disclosure.
FIG. 3 is an explanatory diagram illustrating a planar configuration example of a color filter array 50 according to a comparative example.
FIG. 4 is an explanatory diagram illustrating a planar configuration example of a color filter unit 52a according to a comparative example.
FIG. 5 is an explanatory diagram illustrating a planar configuration example of a color filter unit 52b according to a comparative example.
FIG. 6 is a graph illustrating refractive index characteristics of color filters 54.
FIG. 7A is an explanatory diagram for explaining a first embodiment of the present disclosure (part 1).
FIG. 7B is an explanatory diagram for explaining the first embodiment of the present disclosure (part 2).
FIG. 8A is an explanatory diagram illustrating a planar configuration example of a color filter unit 52 according to the first embodiment of the present disclosure (part 1).
FIG. 8B is an explanatory diagram illustrating a planar configuration example of the color filter unit 52 according to the first embodiment of the present disclosure (part 2).
FIG. 9A is an explanatory diagram for explaining a second embodiment of the present disclosure (part 1).
FIG. 9B is an explanatory diagram for explaining the second embodiment of the present disclosure (part 2).
FIG. 10A is an explanatory diagram illustrating a planar configuration example of the color filter unit 52 according to the second embodiment of the present disclosure (part 1).
FIG. 10B is an explanatory diagram illustrating a planar configuration example of the color filter unit 52 according to the second embodiment of the present disclosure (part 2).
FIG. 11A is an explanatory diagram for explaining a third embodiment of the present disclosure (part 1).
FIG. 11B is an explanatory diagram for explaining the third embodiment of the present disclosure (part 2).
FIG. 12A is an explanatory diagram for explaining the third embodiment of the present disclosure (part 3).
FIG. 12B is an explanatory diagram for explaining the third embodiment of the present disclosure (part 4).
FIG. 13A is an explanatory diagram illustrating a planar configuration example of the color filter unit 52 according to the third embodiment of the present disclosure (part 1).
FIG. 13B is an explanatory diagram illustrating a planar configuration example of the color filter unit 52 according to the third embodiment of the present disclosure (part 2).
FIG. 14 is an explanatory diagram for describing effects according to the embodiments of the present disclosure.
FIG. 15 is an explanatory diagram illustrating a planar configuration example of the color filter unit 52 according to Modification 1 of the embodiments of the present disclosure.
FIG. 16A is an explanatory diagram illustrating a planar configuration example of the color filter unit 52 according to Modification 2 of the embodiments of the present disclosure (part 1).
FIG. 16B is an explanatory diagram illustrating a planar configuration example of the color filter unit 52 according to Modification 2 of the embodiments of the present disclosure (part 2).
FIG. 16C is an explanatory diagram illustrating a planar configuration example of the color filter unit 52 according to Modification 2 of the embodiments of the present disclosure (part 3).
FIG. 17 is an explanatory diagram illustrating a planar configuration example of the color filter unit 52 according to Modification 3 of the embodiments of the present disclosure.
FIG. 18 is an explanatory diagram illustrating a planar configuration example of the color filter unit 52 according to Modification 4 of the embodiments of the present disclosure.
FIG. 19 is an explanatory diagram illustrating a planar configuration example of the color filter unit 52 according to Modification 5 of the embodiments of the present disclosure.
FIG. 20 is an explanatory diagram illustrating an example of a schematic functional configuration of a camera.
FIG. 21 is a block diagram illustrating an example of a schematic functional configuration of a smartphone.
FIG. 22 is a diagram schematically showing the overall configuration of a microscope system.
FIG. 23 is a diagram showing an example of an imaging method.
FIG. 24 is a diagram showing an example of an imaging method.

### Description of Embodiments

Hereinafter, preferred embodiments of the present disclosure will be described in detail with reference to the accompanying drawings. Note that, in the present specification and the drawings, components having substantially the same functional configuration are denoted by the same reference numerals, and redundant description is omitted. In addition, in the present specification and the drawings, a plurality of components having substantially the same or similar functional configuration may be distinguished by attaching different alphabets after the same reference numeral. However, in a case where it is not particularly necessary to distinguish each of a plurality of components having substantially the same or similar functional configuration, only the same reference numeral is attached.

In addition, the drawings referred to in the following description are drawings for promoting description and understanding of an embodiment of the present disclosure, and shapes, dimensions, ratios, and the like illustrated in the drawings may be different from actual ones for the sake of clarity. Furthermore, an imaging device illustrated in the drawings can be appropriately modified in design in consideration of the following description and known techniques.

Note that the description will be given in the following order.
1. Schematic configuration of imaging device
1.1 Imaging device
1.2 Imaging element
1.3 Color filter
2. Background to creation of embodiments of present disclosure
3. Embodiments of present disclosure
3.1 First embodiment
3.2 Second embodiment
3.3 Third embodiment
3.4 Effects
3.5 Modification 1
3.6 Modification 2
3.7 Modification 3
3.8 Modification 4
3.9 Modification 5
4. Summary
5. Application examples
5.1 Application example to camera
5.2 Application example to smartphone
5.3 Application example to microscope system
6. Supplement

### <<1. Schematic configuration of imaging device>>

### <1.1 Imaging device>

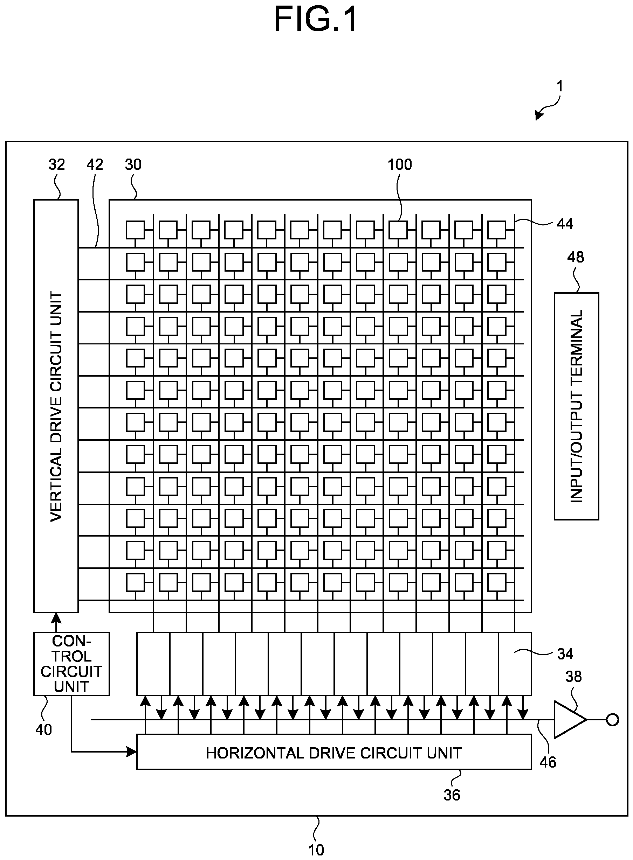

First, a schematic configuration of an imaging device 1 according to embodiments of the present disclosure will be described with reference to FIG. 1. FIG. 1 is an explanatory diagram illustrating a planar configuration example of the imaging device 1 according to the embodiments of the present disclosure. As illustrated in FIG. 1, the imaging device 1 according to the embodiments of the present disclosure includes, for example, a pixel array unit 30 in which a plurality of imaging elements (pixels) 100 is arranged in a matrix on a semiconductor substrate 10 made of silicon and a peripheral circuit unit provided so as to surround the pixel array unit 30. Furthermore, the imaging device 1 includes, as the peripheral circuit unit, a vertical drive circuit unit 32, a column signal processing circuit unit 34, a horizontal drive circuit unit 36, an output circuit unit 38, a control circuit unit 40, and the like. Hereinafter, details of each block of the imaging device 1 will be described.

### (Pixel Array Unit 30)

The pixel array unit 30 includes the plurality of imaging elements 100 two-dimensionally arranged in a matrix along a row direction and a column direction on the semiconductor substrate 10. Each imaging element 100 includes a photodiode (photoelectric conversion unit) (not illustrated) that performs photoelectric conversion on incident light to generate a charge, and a plurality of pixel transistors (for example, metal-oxide-semiconductor (MOS) transistors) (not illustrated). The pixel transistor includes, for example, four MOS transistors of a transfer transistor, a selection transistor, a reset transistor, and an amplification transistor. Note that a detailed structure of the imaging element 100 will be described later.

### (Vertical Drive Circuit Unit 32)

The vertical drive circuit unit 32 is formed by, for example, a shift register, selects a pixel drive wiring line 42, supplies a pulse for driving the imaging element 100 to the selected pixel drive wiring line 42, and drives the imaging element 100 in units of rows. That is, the vertical drive circuit unit 32 selectively scans imaging elements 100 of the pixel array unit 30 sequentially in a vertical direction (an up-and-down direction in FIG. 1) in units of rows, and supplies a pixel signal based on a signal charge generated according to an amount of light received by the photoelectric conversion unit (not illustrated) of each imaging element 100 to the column signal processing circuit unit 34 described later through a vertical signal line 44.

### (Column Signal Processing Circuit Unit 34)

The column signal processing circuit unit 34 is arranged for each column of the imaging elements 100, and performs signal processing such as noise removal for each pixel column on the pixel signals output from the imaging elements 100 for one row. For example, the column signal processing circuit unit 34 performs signal processing such as correlated double sampling (CDS) and analog-digital (AD) conversion in order to remove fixed pattern noise unique to pixels.

### (Horizontal Drive Circuit Unit 36)

The horizontal drive circuit unit 36 is formed by, for example, a shift register, sequentially selects the column signal processing circuit units 34 described above by sequentially outputting horizontal scanning pulses, and causes each of the column signal processing circuit units 34 to output a pixel signal to a horizontal signal line 46.

### (Output Circuit Unit 38)

The output circuit unit 38 performs signal processing on the pixel signals sequentially supplied from the column signal processing circuit units 34 described above through the horizontal signal line 46, and outputs the pixel signals. The output circuit unit 38 may function as, for example, a functional unit that performs buffering, or may perform processing such as black level adjustment, column variation correction, and various digital signal processing. Note that the buffering refers to temporarily storing pixel signals in order to compensate for differences in processing speed and transfer speed when the pixel signals are exchanged. Furthermore, an input/output terminal 48 is a terminal for exchanging signals with an external device.

### (Control Circuit Unit 40)

The control circuit unit 40 receives an input clock and data instructing an operation mode or the like, and outputs data such as internal information of the imaging device 1. That is, the control circuit unit 40 generates a clock signal or a control signal serving as a reference of operations of the vertical drive circuit unit 32, the column signal processing circuit unit 34, the horizontal drive circuit unit 36, and the like on the basis of a vertical synchronization signal, a horizontal synchronization signal, and a master clock. Then, the control circuit unit 40 outputs the generated clock signal or control signal to the vertical drive circuit unit 32, the column signal processing circuit unit 34, the horizontal drive circuit unit 36, and the like.

### <1.2 Imaging element>

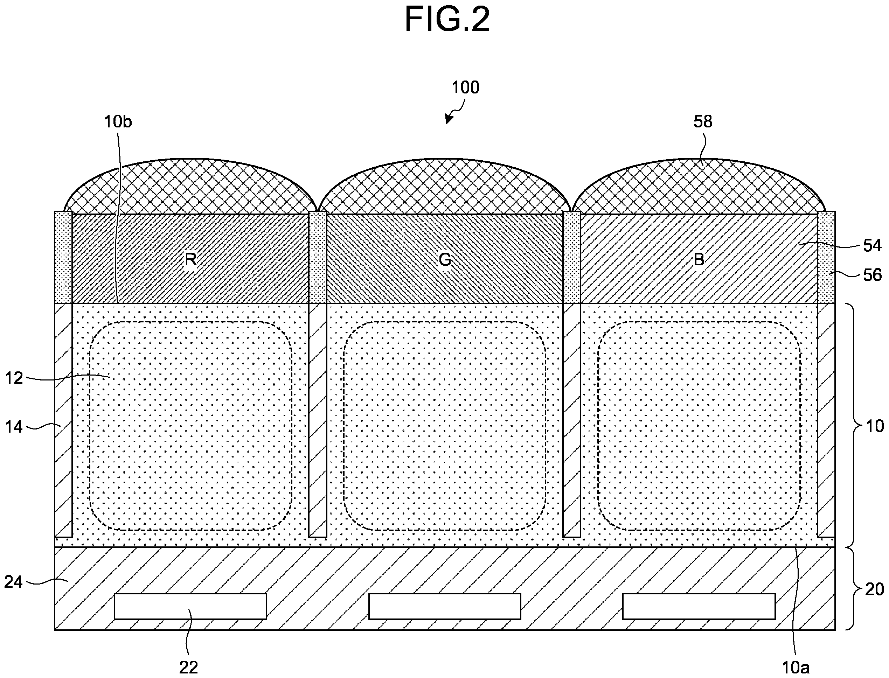

Next, a schematic configuration of the imaging element 100 according to the embodiments of the present disclosure will be described with reference to FIG. 2. FIG. 2 is an explanatory diagram illustrating a part of a cross section of the imaging element 100 according to the embodiments of the present disclosure, and specifically corresponds to a cross section obtained by cutting the imaging element 100 along a thickness direction of the semiconductor substrate 10.

As illustrated in FIG. 2, the plurality of imaging elements 100 is provided on the semiconductor substrate 10 so as to be adjacent to each other. The imaging element 100 mainly includes a color filter 54, a light shielding portion 56, an on-chip lens 58, the semiconductor substrate 10, and a wiring layer 20. Furthermore, the imaging element 100 includes a photoelectric conversion unit 12 provided in the semiconductor substrate 10 and an element separation wall 14 that separates the imaging elements 100. Hereinafter, a laminated structure of the imaging element 100 will be described, but in the following description, description will be made in order from an upper side to a lower side in FIG. 2.

First, as illustrated in FIG. 2, the imaging element 100 includes one on-chip lens 58 provided above a light receiving surface (back surface) 10b of the semiconductor substrate 10 and condensing incident light on the photoelectric conversion unit 12 to be described later.

Then, the incident light condensed by the on-chip lens 58 is incident on the photoelectric conversion unit 12 via the color filter 54 provided below the on-chip lens 58. The color filter 54 can be, for example, a color filter that transmits light having a red wavelength component (for example, a wavelength of 620 nm to 750 nm) (indicated by "R" in FIG. 2), a color filter that transmits light having a green wavelength component (for example, a wavelength of 495 nm to 570 nm) (indicated by "G" in FIG. 2), a color filter that transmits light having a blue wavelength component (for example, a wavelength of 450 nm to 495 nm) (indicated by "B" in FIG. 2), or the like. In addition, the color filter 54 can be formed of, for example, a material in which a pigment or a dye is dispersed in a transparent binder such as silicone. Note that details of the color filter 54 according to the embodiments of the present disclosure will be described later.

Note that, in the drawings attached to the present specification, the color filter (first color filter) 54 that transmits the light having the red wavelength component is denoted by "R", the color filter (second color filter) 54 that transmits the light having the green wavelength component is denoted by "G", and the color filter (third color filter) 54 that transmits the light having the blue wavelength component is denoted by "B". Furthermore, in the drawings, the color filter 54 that transmits light having a white wavelength component is indicated by "W", and the color filter 54 that transmits light having a yellow wavelength component is indicated by "Y". In addition, the color filter 54 that transmits light having a cyan wavelength component is denoted by "C", the color filter 54 that transmits light having a magenta wavelength component is denoted by "M", and the color filter 54 that transmits light having a jade green wavelength component is denoted by "J".

Further, the light shielding portion 56 is provided on the light receiving surface (back surface) 10b of the semiconductor substrate 10 so as to surround the color filter 54. The light shielding portion 56 is provided between the adjacent imaging elements 100 to shield light between the adjacent imaging elements 100.

Furthermore, for example, the photoelectric conversion unit 12 having impurities of a first conductivity type (for example, n-type) is provided for each imaging element 100 in the semiconductor substrate 10 having a second conductivity type (for example, p-type). The photoelectric conversion unit 12 absorbs the light having the red wavelength component, the green wavelength component, the blue wavelength component, or the like incident through the color filter 54 described above, and generates a charge.

Note that, in the embodiments of the present disclosure, each imaging element 100 may be separated into a plurality of pixels (not illustrated) by a pixel separation wall (not illustrated), and the plurality of pixels may function as phase difference detection pixels.

Furthermore, the element separation wall 14 surrounding the imaging element 100 and physically separating adjacent imaging elements 100 from each other is provided in the semiconductor substrate 10. The element separation wall 14 is made of, for example, deep trench isolation (DTI). The DTI is formed by forming a trench penetrating from the light receiving surface (back surface) 10b side of the semiconductor substrate 10 to the middle of the semiconductor substrate 10 or the entire semiconductor substrate 10 along the thickness direction of the semiconductor substrate 10, and embedding a material including an oxide film or a metal film in the trench.

Furthermore, the charge generated by the photoelectric conversion unit 12 is transferred to a floating diffusion unit (not illustrated) provided in a semiconductor region having the first conductivity type (for example, n-type) provided in the semiconductor substrate 10 via a transfer gate (not illustrated) provided on a front surface 10a located on an opposite side of the light receiving surface (back surface) 10b of the semiconductor substrate 10. The wiring layer 20 on the front surface 10a of the semiconductor substrate 10 is formed of a wiring line 22, an insulating film 24, and the like. The wiring layer 20 is provided with a plurality of pixel transistors (not illustrated) for transferring charges and reading out charges as pixel signals, and the wiring line 22 for electrically connecting these transistors.

Note that the imaging element 100 according to the embodiments of the present disclosure is not limited to the configuration illustrated in FIG. 2.

### <1.3 Color filter>

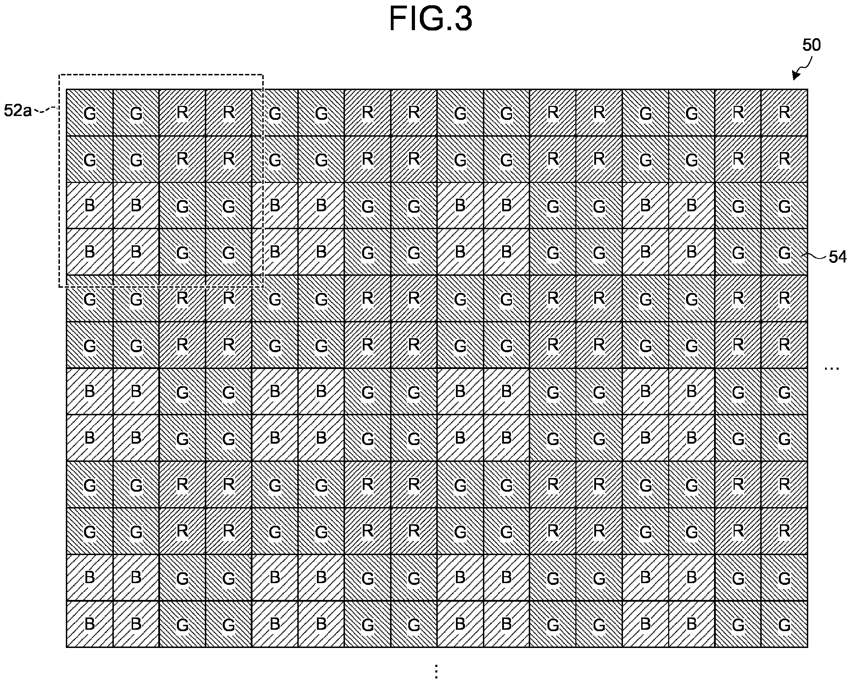

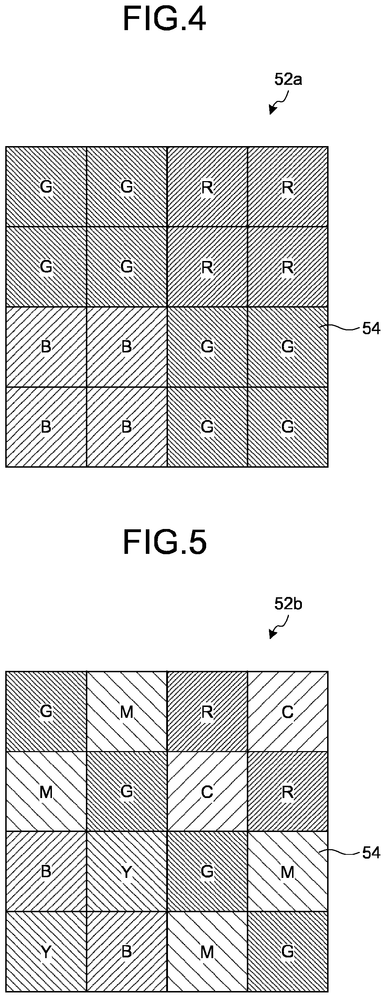

Next, an example of planar arrangement of the color filters 54 will be described with reference to FIGS. 3 to 5. FIG. 3 is an explanatory diagram illustrating a planar configuration example of a color filter array 50 according to a comparative example, FIG. 4 is an explanatory diagram illustrating a planar configuration example of a color filter unit 52a according to a comparative example, and FIG. 5 is an explanatory diagram illustrating a planar configuration example of a color filter unit 52b according to a comparative example. Note that, here, the comparative example means planar arrangement or the like of the imaging device 1 and the color filter 54 that have been repeatedly studied by the present inventors before the embodiments of the present disclosure are made.

As described above, the color filter 54 is provided corresponding to one imaging element 100, and the plurality of imaging elements 100 is arranged in a matrix in the pixel array unit 30 along the row direction and the column direction (two-dimensional array arrangement). Therefore, as illustrated in FIG. 3, the plurality of color filters 54 is regularly arranged in a matrix to form the color filter array 50. As described above, each of the color filters 54 can transmit light of a specific wavelength (for example, red light, green light, blue light, or the like) and cause the transmitted light to enter the photoelectric conversion unit 12 of the imaging element 100. Note that, in the present specification, a type of the color filter 54 is distinguished according to a wavelength of light transmitted through the color filter 54, and a type of the imaging element 100 corresponding to the color filter 54 is also distinguished. Furthermore, each color filter 54 has a rectangular shape such as a square in plan view.

Furthermore, as illustrated in FIG. 3, the color filter array 50 is configured by two-dimensionally arranging the color filter units (unit regions) 52a each configured by arranging a predetermined number of color filters 54 in m rows and n columns (in the example of FIG. 3, four rows and four columns). Note that, in the embodiments of the present disclosure, the number of arrangement of the color filters 54 in the color filter unit 52a is not limited to four rows and four columns as illustrated in FIG. 3.

Specifically, in a case of the comparative example illustrated in FIG. 4, the color filter unit 52a includes the plurality of color filters 54 arranged in four rows and four columns in a two-dimensional manner according to the Bayer arrangement. Here, the Bayer arrangement is an arrangement pattern in which the color filters 54 that transmit light having a green wavelength component are arranged in a checkered pattern and the color filters 54 that transmit light having a red wavelength component and the color filters 54 that transmit light having a blue wavelength component are alternately arranged for each column in a remaining portion. More specifically, in the example of FIG. 4, the color filters 54 that transmit green light arranged in two rows and two columns are arranged on the upper left and the lower right of the color filter unit 52a, the color filters 54 that transmit red light arranged in two rows and two columns are arranged on the upper right of the color filter unit 52a, and the color filters 54 that transmit blue light arranged in two rows and two columns are arranged on the lower left of the color filter unit 52a.

Meanwhile, in such a conventional Bayer arrangement, there is a limit to color reproducibility and noise suppression. Therefore, it is proposed to use the color filters 54 that transmit the light of three colors corresponding to the Bayer arrangement and the color filters 54 that transmit light of colors having complementary color relationships with the light of these colors. For example, a color filter unit 52b illustrated in FIG. 5 includes the color filter 54 that transmits cyan light having a complementary color relationship with the red light, the color filter 54 that transmits magenta light having a complementary color relationship with the green light, and the color filter 54 that transmits yellow light having a complementary color relationship with the blue light. However, according to the study of the present inventors, it has been found that there is a limit to the color reproducibility and the noise suppression even when the color filters 54 that transmit light of colors having such complementary color relationships are used. Then, from such a situation, the present inventors have created the embodiments of the present disclosure. Hereinafter, a background leading to the creation of the embodiments of the present disclosure by the present inventors will be described.

### <<2. Background to creation of embodiments of present disclosure>>

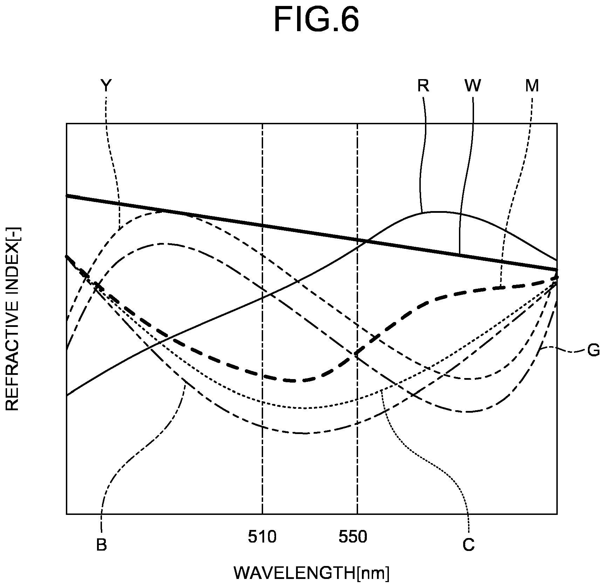

The background leading to the creation of the embodiments of the present disclosure by the present inventors will be described with reference to FIG. 6. FIG. 6 is a graph illustrating a refractive index characteristic of each color filter 54.

In the situation described above, in order to further improve the color reproducibility and the noise suppression, the present inventors have intensively studied a combination of color filters 54 that transmit light of various colors. While conducting such studies, the present inventors have found that the color reproducibility is improved by combining with the color filter 54 such as the color filter 54 that transmits cyan light or the color filter 54 that transmits jade green light and the noise suppression is enhanced by combining with the color filter 54 such as the color filter 54 that transmits white light, the color filter 54 that transmits yellow light, or the color filter 54 that transmits magenta light. That is, according to findings of the present inventors, it has been found that by combining the color filter 54 that improves the color reproducibility and the color filter 54 that enhances the noise suppression as described above with the color filters 54 that transmits red light, green light, and blue light, it is possible to obtain both effects of improving the color reproducibility and the noise suppression.

However, the inventors of the present invention have conducted deeper studies, and resultantly found that when the above-described color filters 54 are simply combined, spectral characteristics are deteriorated due to the color filters 54 that transmit light of colors adjacent to each other and having a complementary color relationship, and the effects of color reproducibility and noise suppression may not be obtained. Furthermore, it has been found that the more the imaging element 100 is miniaturized, the more easily the imaging element is affected by the color filter 54 having the complementary color relationship.

Specifically, each color filter 54 has a refractive index characteristic as illustrated in FIG. 6. Specifically, FIG. 6 illustrates refractive indexes of the color filter 54 that transmits red light, the color filter 54 that transmits green light, the color filter 54 that transmits blue light, the color filter 54 that transmits cyan light, the color filter 54 that transmits yellow light, the color filter 54 that transmits white light, and the color filter 54 that transmits magenta light with respect to a wavelength of light. Note that, in the present specification, a refractive index of the color filter 54 that transmits jade green light is regarded as being similar to the refractive index of the color filter 54 that transmits green light. Furthermore, the refractive index characteristic illustrated in FIG. 6 is an example, and in the embodiments of the present disclosure, the refractive index of each color filter 54 is not limited to having the refractive index characteristic as illustrated in FIG. 6.

As can be seen from FIG. 6, the refractive index of the color filter 54 that transmits white light gradually decreases from a short wavelength toward a long wavelength. In addition, the refractive indexes of the color filter 54 that transmits blue light and the color filter 54 that transmits cyan light change in a downward convex curved shape in which the refractive index is the smallest from 510 nm to 580 nm. Furthermore, the color filter 54 that transmits red light, the color filter 54 that transmits green light, the color filter 54 that transmits yellow light, and the color filter 54 that transmits magenta light change in a curved shape having one or two peaks. Then, as can be seen from FIG. 6, a refractive index level relationship between the color filters 54 changes according to the wavelength of light.

In addition, since the light has a property of proceeding from a low refractive index to a high refractive index, easiness of guiding the light to each of the color filters 54 is determined by the refractive index level relationship between the two adjacent color filters 54.

Therefore, due to the refractive index level relationship between the two adjacent color filters 54, light is guided to one color filter 54 more than necessary, or necessary light is not guided to one color filter 54. According to the studies of the present inventors, it is considered that due to such a refractive index level relationship, the spectral characteristics are deteriorated, and the effects of color reproducibility and noise suppression may not be obtained.

Therefore, in view of such a situation, the present inventors have created embodiments of the present disclosure that can obtain the effects of improving the color reproducibility and suppressing the noise by arranging the color filters 54 in consideration of the refractive index level relationship between the adjacent color filters 54. Hereinafter, details of embodiments of the present disclosure will be sequentially described.

### <<3. Embodiments of present disclosure>>

### <3.1 First embodiment>

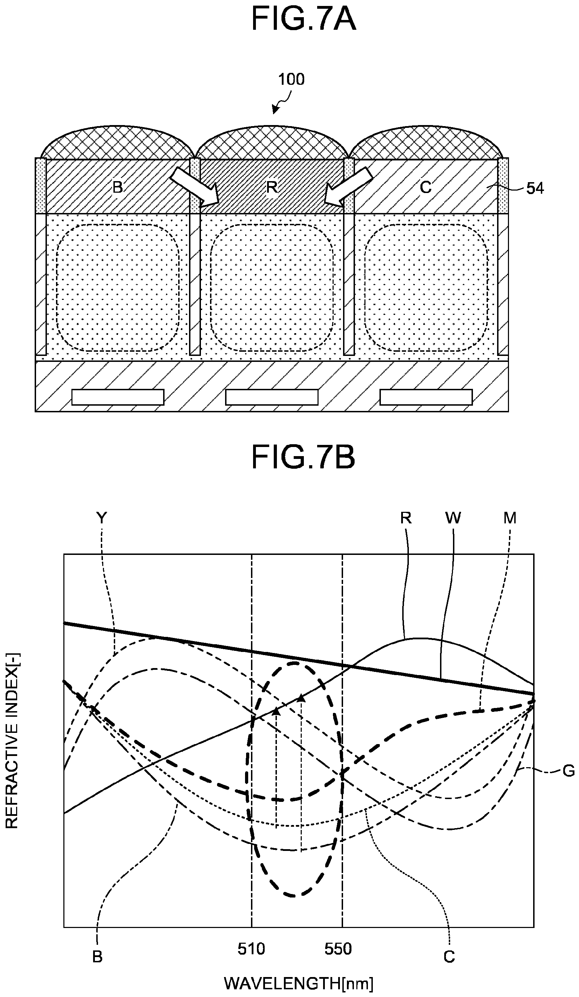

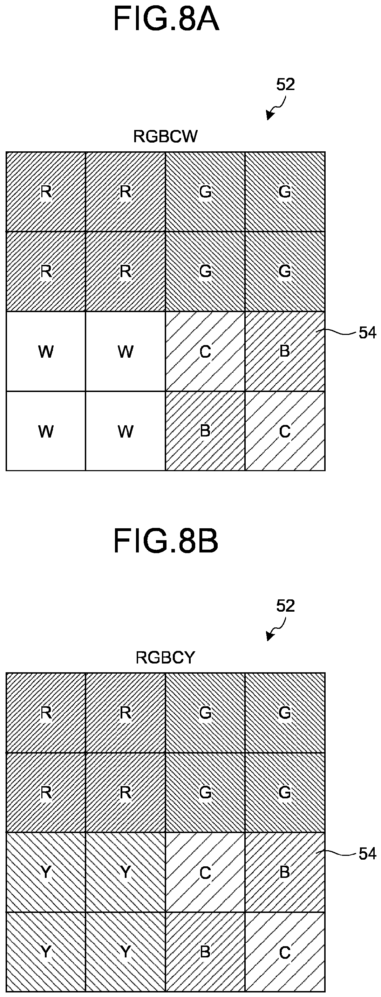

First, a first embodiment of the present disclosure will be described with reference to FIGS. 7A to 8B. FIGS. 7A and 7B are explanatory diagrams for describing the present embodiment, and FIGS. 8A and 8B are explanatory diagrams illustrating a planar configuration example of a color filter unit 52 according to the present embodiment.

First, a concept of the present embodiment will be described with reference to FIGS. 7A and 7B. As illustrated in FIG. 7B, at a wavelength of 510 nm to 550 nm, the color filter 54 that transmits red light has a refractive index higher than those of the color filter 54 that transmits blue light and the color filter 54 that transmits cyan light. Therefore, for example, as illustrated in FIG. 7A, in a case where the color filter 54 that transmits blue light and the color filter 54 that transmits cyan light are arranged so as to be adjacent to the color filter 54 that transmits red light, since light has a property of traveling from a lower refractive index to a higher refractive index, light incident on the color filter 54 that transmits blue light and the color filter 54 that transmits cyan light easily travels to the color filter 54 that transmits red light. Therefore, in a case where the color filters 54 are arranged as illustrated in FIG. 7A, color mixing occurs in the imaging element (first imaging element) 100 corresponding to the color filter 54 that transmits red light due to the light from the adjacent imaging elements 100. As a result, the imaging device 1 detects the red light more than it actually is.

Therefore, in the present embodiment, the color filter 54 that transmits blue light and the color filter 54 that transmits cyan light are not arranged so as to be adjacent to the color filter 54 that transmits red light, thereby preventing color mixing in the imaging element 100 corresponding to the color filter 54 that transmits red light. Hereinafter, details of the present embodiment will be described.

In the present embodiment, similarly to the comparative examples, the color filter array 50 is configured by two-dimensionally arranging the color filter units (unit regions) 52 configured by arranging the predetermined number of color filters 54 in m rows and n columns. Furthermore, each of the color filters 54 can transmit light of a specific wavelength (for example, red light, green light, blue light, cyan light, yellow light, white light, magenta light, jade green light, or the like) and cause the transmitted light to enter the photoelectric conversion unit 12 of the imaging element 100. Furthermore, in the present embodiment, each of the color filters 54 and the imaging elements 100 has a rectangular shape in plan view.

Specifically, the color filter unit 52 according to the present embodiment includes the color filter (second color filter) 54 that transmits green light, the color filter (first color filter) 54 that transmits red light, and the color filter (third color filter) 54 that transmits blue light. Furthermore, the color filter unit 52 includes at least one color filter 54 of the color filter 54 that transmits cyan light and the color filter 54 that transmits jade green light. In addition, the color filter unit 52 includes at least one color filter 54 selected from a group consisting of the color filter 54 that transmits white light, the color filter 54 that transmits yellow light, and the color filter 54 that transmits magenta light. In the present embodiment, by including these color filters 54, effects of improving color reproducibility and suppressing noise can be obtained. That is, the color filter unit 52 according to the present embodiment includes five or more types of color filters 54 distinguished by the wavelengths of light transmitted through the color filter 54.

Furthermore, in the color filter unit 52 according to the present embodiment, the color filter 54 that transmits red light and the color filter (fourth color filter) 54 having a refractive index lower than that of the color filter 54 that transmits red light at the wavelength of 510 nm to 550 nm are not arranged so as to be in contact with each other on two or more sides of the color filter 54 that transmits red light. In other words, in the present embodiment, the imaging element 100 corresponding to the color filter 54 that transmits red light and the imaging element (fourth imaging element) 100 corresponding to the color filter 54 having a refractive index lower than that of the color filter 54 that transmits red light at the wavelength of 510 nm to 550 nm are not arranged so as to be in contact with each other on two or more sides of the imaging element 100 corresponding to the color filter 54 that transmits red light. Specifically, in the present embodiment, the color filter 54 that is not adjacent to the color filter 54 that transmits red light is assumed to be the color filter 54 having a refractive index lower than that of the color filter 54 that transmits red light by 0.1 or more at the wavelength of 510 nm to 550 nm. In the present embodiment, by doing so, color mixing in the imaging element 100 corresponding to the color filter 54 that transmits red light can be prevented.

Specifically, as illustrated in FIGS. 8A and 8B, in the color filter unit 52 according to the present embodiment, the color filter 54 that transmits red light, the color filter 54 that transmits blue light, and the color filter 54 that transmits cyan light are not arranged so as to be in contact with each other on two or more sides of the color filter 54 that transmits red light.

In FIG. 8A, the color filter unit 52 is configured by arranging the color filters 54 in four rows and four columns, and includes five types of color filters 54 distinguished by the wavelengths of light transmitted through the color filters 54. Specifically, as illustrated in FIG. 8A, the color filters 54 that transmit green light are arranged in two rows and two columns on the upper right of the color filter unit 52, and the color filters 54 that transmit red light are arranged in two rows and two columns on the upper left of the color filter unit 52. Furthermore, the color filters 54 that transmit white light are arranged in two rows and two columns on the lower left of the color filter unit 52, and the color filters 54 that transmit light having a blue wavelength and the color filters 54 that transmit cyan light are arranged in a checkered pattern on the lower right of the color filter unit 52.

Furthermore, in the color filter unit 52 illustrated in FIG. 8B, the color filters 54 that transmit white light in the example of FIG. 8A are replaced with the color filters 54 that transmit yellow light.

As described above, in the present embodiment, since the color filter unit 52 includes the color filters 54 that transmit cyan light and includes the color filters 54 that transmit white light or the color filters 54 that transmit yellow light, it is possible to obtain effects of improving color reproducibility and suppressing noise. Furthermore, in the present embodiment, in the color filter unit 52, the color filter 54 that transmits red light and the color filter 54 having a refractive index lower than that of the color filter 54 that transmits red light at the wavelength of 510 nm to 550 nm (specifically, the color filter 54 that transmits blue light and the color filter 54 that transmits cyan light) are not arranged so to be in contact with each other on two or more sides of the color filter 54 that transmits red light. In the present embodiment, by doing so, color mixing in the imaging element 100 corresponding to the color filter 54 that transmits red light can be prevented.

Note that, in the embodiment of the present disclosure, some of the imaging elements 100 may be separated into a plurality of pixels (not illustrated) by a pixel separation wall (not illustrated), and the plurality of pixels may function as phase difference detection pixels.

### <3.2 Second embodiment>

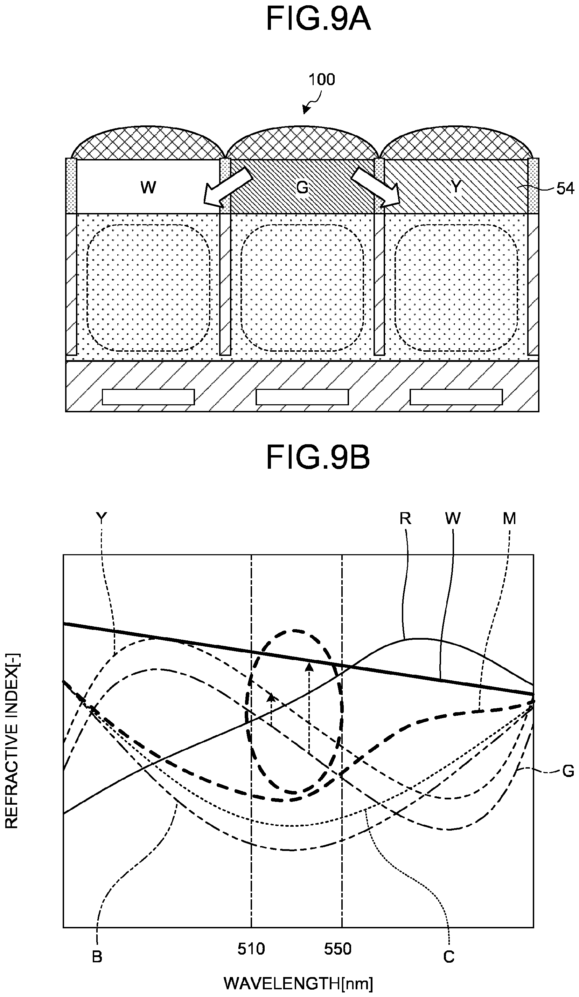

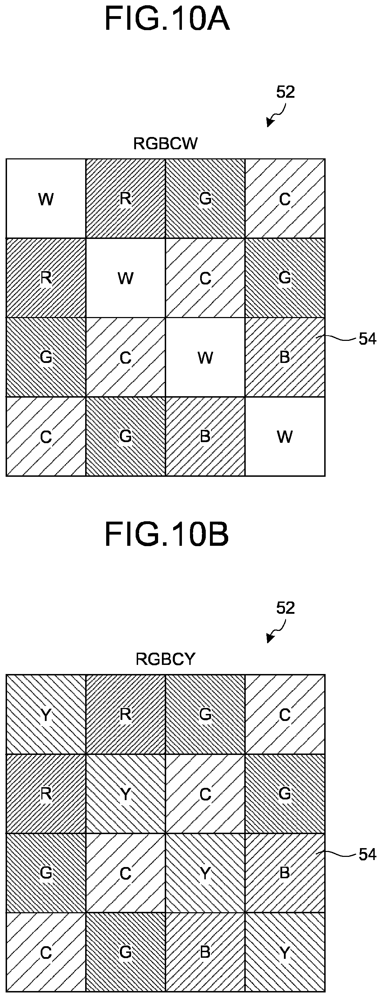

Next, a second embodiment of the present disclosure will be described with reference to FIGS. 9A to 10B. FIGS. 9A and 9B are explanatory diagrams for describing the present embodiment, and FIGS. 10A and 10B are explanatory diagrams illustrating a planar configuration example of the color filter unit 52 according to the present embodiment.

First, a concept of the present embodiment will be described with reference to FIGS. 9A and 9B. As illustrated in FIG. 7B, at the wavelength of 510 nm to 550 nm, the color filter 54 that transmits green light has a lower refractive index than the color filter 54 that transmits yellow light and the color filter 54 that transmits white light. Therefore, for example, as illustrated in FIG. 9A, in a case where the color filter 54 that transmits yellow light and the color filter 54 that transmits white light are arranged so as to be adjacent to the color filter 54 that transmits green light, since light has a property of traveling from a lower refractive index to a higher refractive index, light incident on the color filter 54 that transmits green light easily travels to the color filter 54 that transmits yellow light and the color filter 54 that transmits white light. Therefore, in a case where the color filters 54 are arranged as illustrated in FIG. 9A, the light is hardly condensed in the imaging element (second imaging element) 100 corresponding to the color filter 54 that transmits green light, and conversion efficiency is deteriorated. As a result, the imaging device 1 cannot detect the green light as compared with an actual case.

Therefore, in the present embodiment, the color filter 54 that transmits yellow light and the color filter 54 that transmits white light are not arranged so as to be adjacent to the color filter 54 that transmits green light, thereby preventing deterioration of the conversion efficiency of the imaging element 100 corresponding to the color filter 54 that transmits green light. Hereinafter, details of the present embodiment will be described.

In the color filter unit 52 according to the present embodiment, the color filter 54 that transmits green light and the color filter (fifth color filter) 54 having a refractive index higher than that of the color filter 54 that transmits green light at the wavelength of 510 nm to 550 nm are not arranged so as to be in contact with each other on two or more sides of the color filter 54 that transmits green light. In other words, in the present embodiment, the imaging element 100 corresponding to the color filter 54 that transmits green light and the imaging element (fifth imaging element) 100 corresponding to the color filter 54 having a refractive index higher than that of the color filter 54 that transmits green light at the wavelength of 510 nm to 550 nm are not arranged so as to be in contact with each other on two or more sides of the imaging element 100 corresponding to the color filter 54 that transmits green light. Furthermore, in the present embodiment, the color filter 54 that is not adjacent to the color filter 54 that transmits green light is assumed to be the color filter 54 having a refractive index higher than that of the color filter 54 that transmits green light by 0.1 or more at the wavelength of 510 nm to 550 nm. In the present embodiment, by doing so, it is possible to prevent deterioration of the conversion efficiency of the imaging element 100 corresponding to the color filter 54 that transmits green light.

Specifically, as illustrated in FIGS. 10A and 10B, in the color filter unit 52 according to the present embodiment, the color filter 54 that transmits green light, the color filter 54 that transmits white light, and the color filter 54 that transmits yellow light are not arranged so as to be in contact with each other on two or more sides of the color filter 54 that transmits green light.

More specifically, the color filter unit 52 illustrated in FIG. 10A is configured by arranging the color filters 54 in four rows and four columns, and includes five types of color filters 54 distinguished by the wavelengths of light transmitted through the color filters 54. As illustrated in FIG. 8A, the color filters 54 that transmit cyan light and the color filters 54 that transmit green light are arranged in a checkered pattern on the upper right and the lower left of the color filter unit 52. Further, on the upper left of the color filter unit 52, the color filters 54 that transmit white light and the color filters 54 that transmit red light are arranged in a checkered pattern. Furthermore, on the lower right of the color filter unit 52, the color filters 54 that transmit white light and the color filters 54 that transmit blue light are arranged in a checkered pattern.

Furthermore, in the color filter unit 52 illustrated in FIG. 10B, the color filters 54 that transmit white light in the example of FIG. 10A are replaced with the color filters 54 that transmit yellow light.

As described above, in the present embodiment, since the color filter unit 52 includes the color filters 54 that transmit cyan light and includes the color filters 54 that transmit white light or the color filters 54 that transmit yellow light, it is possible to obtain effects of improving color reproducibility and suppressing noise. Furthermore, in the present embodiment, in the color filter unit 52, the color filter 54 that transmits green light and the color filter 54 having a refractive index higher than that of the color filter 54 that transmits green light at the wavelength of 510 nm to 550 nm (specifically, the color filter 54 that transmits white light and the color filter 54 that transmits yellow light) are not arranged so as to be in contact with each other on two or more sides of the color filter 54 that transmits green light. In the present embodiment, by doing so, it is possible to prevent deterioration of the conversion efficiency of the imaging element 100 corresponding to the color filter 54 that transmits green light.

### <3.3 Third embodiment>

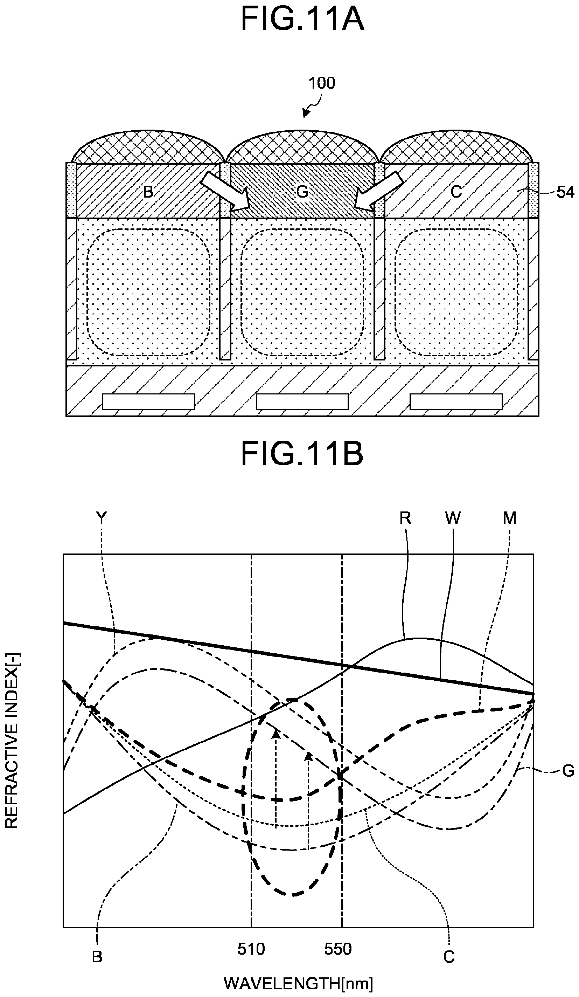

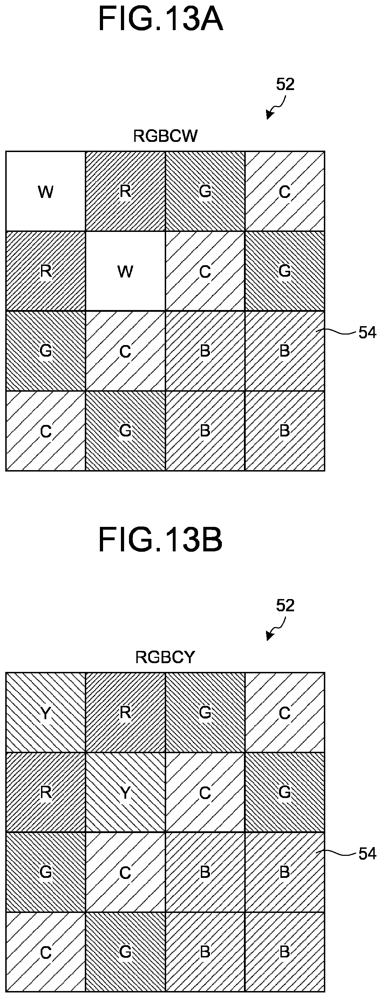

Next, a third embodiment of the present disclosure will be described with reference to FIGS. 11A to 13B. FIGS. 11A to 12B are explanatory diagrams for describing the present embodiment, and FIGS. 13A and 13B are explanatory diagrams illustrating a planar configuration example of the color filter unit 52 according to the present embodiment.

First, a concept of the present embodiment will be described with reference to FIGS. 11A and 11B.

Meanwhile, in order to be able to reproduce a color closer to a color when viewed with human eyes, the imaging device 1 preferably detects green light with higher accuracy. Therefore, it is required to improve conversion efficiency of the imaging element 100 corresponding to the color filter 54 that transmits green light.

Therefore, for example, as illustrated in FIG. 11A, it is conceivable to arrange the color filter 54 that transmits blue light and the color filter 54 that transmits cyan light so as to be adjacent to the color filter 54 that transmits green light. Specifically, as illustrated in FIG. 11B, at the wavelength of 510 nm to 550 nm, the color filter 54 that transmits green light has a refractive index higher than those of the color filter 54 that transmits blue light and the color filter 54 that transmits cyan light. Since light has a property of traveling from a lower refractive index to a higher refractive index, light incident on the color filter 54 that transmits blue light and the color filter 54 that transmits cyan light easily travels to the color filter 54 that transmits green light. As a result, the conversion efficiency of the imaging element 100 corresponding to the color filter 54 that transmits green light can be improved.

That is, in the color filter unit 52 according to the present embodiment, the color filter 54 that transmits green light and the color filter (sixth color filter) 54 having a refractive index lower than that of the color filter 54 that transmits green light at the wavelength of 510 nm to 550 nm are arranged so as to be in contact with each other. In other words, in the present embodiment, the imaging element 100 corresponding to the color filter 54 that transmits green light and the imaging element (sixth imaging element) 100 corresponding to the color filter 54 having a refractive index lower than that of the color filter 54 that transmits green light at the wavelength of 510 nm to 550 nm are arranged so as to be in contact with each other. Furthermore, in the present embodiment, the color filter 54 adjacent to the color filter 54 that transmits green light is the color filter 54 having a refractive index lower than that of the color filter 54 that transmits green light by 0.1 or more at the wavelength of 510 nm to 550 nm. In the present embodiment, by doing so, the conversion efficiency of the imaging element 100 corresponding to the color filter 54 that transmits green light can be improved. However, in this case, there is a concern that the conversion efficiency of the imaging element 100 corresponding to the color filter 54 adjacent to the color filter 54 that transmits green light deteriorates.

Therefore, in the following, means for suppressing deterioration of conversion efficiency of the imaging element (third imaging element) 100 corresponding to the color filter 54 that transmits blue light will be examined.

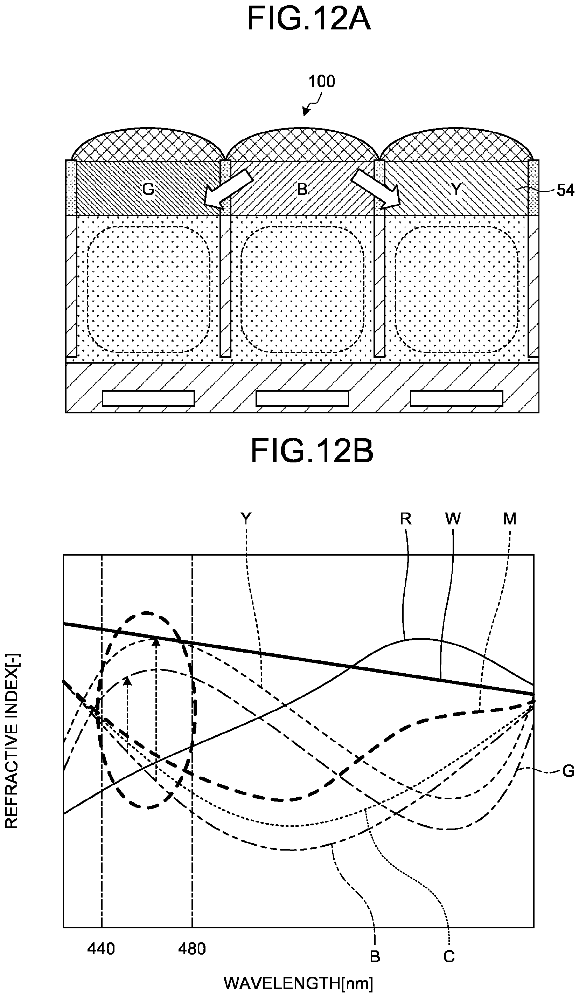

A second concept of the present embodiment will be described with reference to FIGS. 12A and 12B. As illustrated in FIG. 12B, at a wavelength of 440 nm to 480 nm, the color filter 54 that transmits blue light has a lower refractive index than the color filter 54 that transmits yellow light and the color filter 54 that transmits green light. Therefore, for example, as illustrated in FIG. 12A, in a case where the color filter 54 that transmits yellow light and the color filter 54 that transmits green light are arranged so as to be adjacent to the color filter 54 that transmits blue light, since light has a property of traveling from a lower refractive index to a higher refractive index, light incident on the color filter 54 that transmits blue light easily travels to the color filter 54 that transmits yellow light and the color filter 54 that transmits green light. Therefore, in a case where the color filters 54 are arranged as illustrated in FIG. 12A, the light is hardly condensed in the imaging element 100 corresponding to the color filter 54 that transmits blue light, and conversion efficiency is deteriorated. As a result, the imaging device 1 cannot detect the blue light more than actual blue light.

Therefore, in the present embodiment, the color filter 54 that transmits yellow light and the color filter 54 that transmits green light are not arranged so as to be adjacent to the color filter 54 that transmits blue light, thereby suppressing deterioration of the conversion efficiency of the imaging element 100 corresponding to the color filter 54 that transmits blue light.

In the color filter unit 52 according to the present embodiment, the color filter 54 that transmits blue light and the color filter (seventh color filter) 54 having a refractive index higher than that of the color filter 54 that transmits blue light at the wavelength of 440 nm to 480 nm are not arranged so as to be in contact with each other on two or more sides of the color filter 54 that transmits blue light. In other words, in the present embodiment, the imaging element 100 corresponding to the color filter 54 that transmits blue light and the imaging element (seventh imaging element) 100 corresponding to the color filter 54 having a refractive index higher than that of the color filter 54 that transmits blue light at the wavelength of 440 nm to 480 nm are not arranged so as to be in contact with each other on two or more sides of the imaging element 100 corresponding to the color filter 54 that transmits blue light. Furthermore, in the present embodiment, the color filter 54 that is not adjacent to the color filter 54 that transmits blue light is assumed to be the color filter 54 having a refractive index higher than that of the color filter 54 that transmits blue light by 0.1 or more at the wavelength of 440 nm to 480 nm. In the present embodiment, by doing so, it is possible to prevent deterioration of the conversion efficiency of the imaging element 100 corresponding to the color filter 54 that transmits blue light.

Specifically, as illustrated in FIGS. 13A and 13B, in the color filter unit 52 according to the present embodiment, the color filter 54 that transmits green light, the color filter 54 that transmits blue light, and the color filter 54 that transmits cyan light are arranged so as to be in contact with each other. Furthermore, in the color filter unit 52, the color filter 54 that transmits blue light, the color filter 54 that transmits green light, and the color filter 54 that transmits yellow light are not arranged so as to be in contact with each other on two or more sides of the color filter 54 that transmits blue light.

More specifically, in FIG. 13A, the color filter unit 52 is configured by arranging the color filters 54 in four rows and four columns. As illustrated in FIG. 13A, the color filters 54 that transmit cyan light and the color filters 54 that transmit green light are arranged in a checkered pattern on the upper right and the lower left of the color filter unit 52. Further, on the upper left of the color filter unit 52, the color filters 54 that transmit white light and the color filters 54 that transmit red light are arranged in a checkered pattern. Furthermore, the color filters 54 that transmit blue light are arranged in two rows and two columns on the lower right of the color filter unit 52.

Furthermore, in the color filter unit 52 illustrated in FIG. 13B, the color filters 54 that transmit white light in the example of FIG. 13A are replaced with the color filters 54 that transmit yellow light.

As described above, in the present embodiment, since the color filter unit 52 includes the color filters 54 that transmit cyan light and includes the color filters 54 that transmit white light or the color filters 54 that transmit yellow light, it is possible to obtain effects of improving color reproducibility and suppressing noise. Furthermore, in the present embodiment, in the color filter unit 52, the color filter 54 that transmits green light and the color filter 54 having a refractive index lower than that of the color filter 54 that transmits green light at the wavelength of 510 nm to 550 nm (specifically, the color filter 54 that transmits blue light and the color filter 54 that transmits cyan light) are arranged so as to be in contact with each other. In addition, in the present embodiment, in the color filter unit 52, the color filter 54 that transmits blue light and the color filter 54 having a refractive index higher than that of the color filter 54 that transmits blue light at the wavelength of 440 nm to 480 nm (specifically, the color filter 54 that transmits light having a green wavelength and the color filter 54 that transmits yellow light) are not arranged so as to be in contact with each other on two or more sides of the color filter 54 that transmits blue light. In this way, it is possible to prevent deterioration of the conversion efficiency of the imaging element 100 corresponding to the color filter 54 that transmits blue light while improving the conversion efficiency of the imaging element 100 corresponding to the color filter 54 that transmits green light.

### <3.4 Effects>

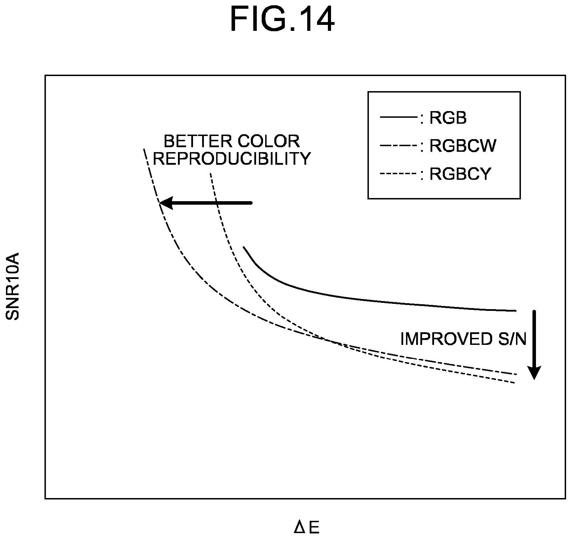

Next, effects of the present embodiment will be described with reference to FIG. 14. FIG. 14 is an explanatory diagram for explaining the effects according to the present embodiment. Specifically, the horizontal axis indicates ΔE, which is a difference between color detected by the imaging device 1 and actual color, as an index of color reproducibility, and the vertical axis indicates SNR10A, which is a reciprocal of a signal/noise (S/N) ratio, as an index of noise suppression.

As can be seen from a simulation result illustrated in FIG. 14, in a case of using the arrangement of the color filters 54 according to the present embodiment (RGBCW/RGBCY), the color reproducibility is good and the noise can also be suppressed as compared with the Bayer arrangement (RGB) according to the comparative example. Specifically, RGBCW in FIG. 14 is a case of the arrangement illustrated in FIG. 8A, and RGBCY in FIG. 14 is a case of the arrangement illustrated in FIG. 8B.

### <3.5 Modification 1>

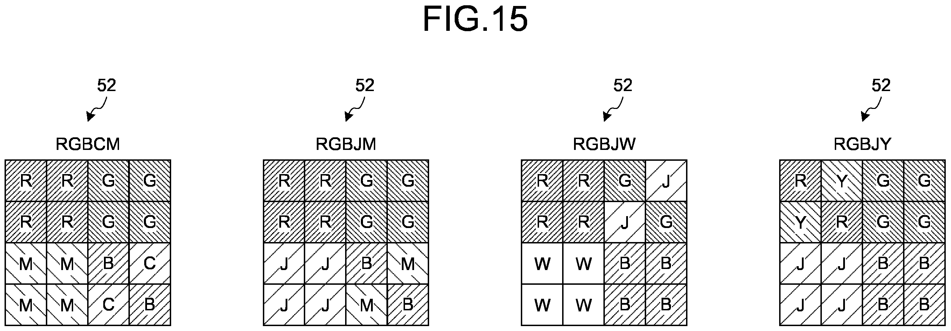

Furthermore, in the embodiments of the present disclosure, the arrangement is not limited to that of the color filters 54 as illustrated in FIGS. 8A, 8B, 10A, 10B, 13A, and 13B. Therefore, Modification 1 of the embodiments of the present disclosure will be described with reference to FIG. 15. FIG. 15 is an explanatory diagram illustrating a planar configuration example of the color filter unit 52 according to Modification 1 of the present embodiments.

Also in the present modification, the color filter unit 52 is configured by arranging the color filters 54 in four rows and four columns, and includes five types of color filters 54 distinguished by the wavelengths of light transmitted through the color filters 54.

More specifically, in the example illustrated on the leftmost side of FIG. 15, the color filters 54 that transmit green light are arranged in two rows and two columns on the upper right of the color filter unit 52, and the color filters 54 that transmit red light are arranged in two rows and two columns on the upper left of the color filter unit 52. Further, the color filters 54 that transmit magenta light are arranged in two rows and two columns on the lower left of the color filter unit 52. Furthermore, the color filters 54 that transmit blue light and the color filters 54 that transmit cyan light are arranged in a checkered pattern on the lower right of the color filter unit 52.

Further, in the example illustrated in the second from the left side of FIG. 15, the color filters 54 that transmit green light are arranged in two rows and two columns on the upper right of the color filter unit 52, and the color filters 54 that transmit red light are arranged in two rows and two columns on the upper left of the color filter unit 52. Further, on the lower left of the color filter unit 52, the color filters 54 that transmit jade green light are arranged in two rows and two columns. Furthermore, on the lower right of the color filter unit 52, the color filters 54 that transmit blue light and the color filters 54 that transmit magenta light are arranged in a checkered pattern.

In the example illustrated in the third from the left side of FIG. 15, the color filters 54 that transmit jade green light and the color filters 54 that transmit green light are arranged in a checkered pattern on the upper right of the color filter unit 52. In addition, the color filters 54 that transmit red light are arranged in two rows and two columns on the upper left of the color filter unit 52, and the color filters 54 that transmit white light are arranged in two rows and two columns on the lower left of the color filter unit 52. Furthermore, the color filters 54 that transmit blue light are arranged in two rows and two columns on the lower right of the color filter unit 52.

Further, in the example illustrated on the right side of FIG. 15, the color filters 54 that transmit green light are arranged in two rows and two columns on the upper right of the color filter unit 52, and the color filters 54 that transmit red light and the color filters 54 that transmit yellow light are arranged in a checkered pattern on the upper left of the color filter unit 52. Furthermore, the color filters 54 that transmit light having a wavelength of jade green light are arranged in two rows and two columns on the lower left of the color filter unit 52, and the color filters 54 that transmit blue light are arranged in two rows and two columns on the lower right of the color filter unit 52.

### <3.6 Modification 2>

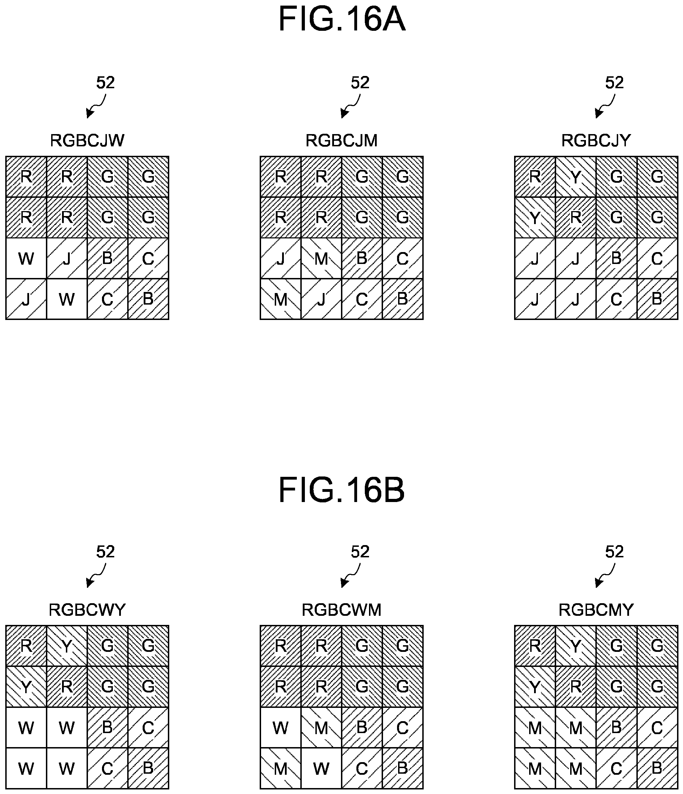

Further, in the embodiments of the present disclosure, the color filter unit 52 may include six types of color filters 54 distinguished by the wavelengths of light transmitted through the color filters 54. Therefore, such a modification will be described with reference to FIGS. 16A to 16C. FIGS. 16A to 16C are explanatory diagrams illustrating a planar configuration example of the color filter unit 52 according to Modification 2 of the present embodiments.

Specifically, also in the present modification, the color filter unit 52 includes the color filters 54 that transmit green light, the color filters 54 that transmit red light, and the color filters 54 that transmit blue light. Furthermore, the color filter unit 52 according to the present modification includes one or two color filters 54 selected from the color filter 54 that transmits cyan light and the color filter 54 that transmits jade green light. In addition, the color filter unit 52 according to the present modification includes one or two color filters 54 selected from a group consisting of the color filter 54 that transmits white light, the color filter 54 that transmits yellow light, and the color filter 54 that transmits magenta light.

More specifically, in the example illustrated on the left side of FIG. 16A, the color filters 54 that transmit green light are arranged in two rows and two columns on the upper right of the color filter unit 52, and the color filters 54 that transmit red light are arranged in two rows and two columns on the upper left of the color filter unit 52. In addition, the color filters 54 that transmit white light and the color filters 54 that transmit jade green light are arranged in a checkered pattern on the lower left of the color filter unit 52, and the color filters 54 that transmit blue light and the color filters 54 that transmit cyan light are arranged in a checkered pattern on the lower right of the color filter unit 52.

In the color filter unit 52 illustrated in the center of FIG. 16A, the color filters 54 transmitting jade green light in the example on the left side of FIG. 16A are replaced with the color filters 54 transmitting magenta light, and the color filters 54 transmitting white light are replaced with the color filters 54 transmitting light having a wavelength of jade green light.

Furthermore, in the example illustrated on the right side of FIG. 16A, the color filters 54 that transmit green light are arranged in two rows and two columns on the upper right of the color filter unit 52, and the color filters 54 that transmit red light and the color filters 54 that transmit yellow light are arranged in a checkered pattern on the upper left of the color filter unit 52. Furthermore, the color filters 54 that transmit light having a wavelength of jade green light are arranged in two rows and two columns on the lower left of the color filter unit 52, and the color filters 54 that transmit blue light and the color filters 54 that transmit cyan light are arranged in a checkered pattern on the lower right of the color filter unit 52.

In the example illustrated on the left side of FIG. 16B, the color filters 54 that transmit green light are arranged in two rows and two columns on the upper right of the color filter unit 52, and the color filters 54 that transmit red light and the color filters 54 that transmit yellow light are arranged in a checkered pattern on the upper left of the color filter unit 52. Furthermore, the color filters 54 that transmit white light are arranged in two rows and two columns on the lower left of the color filter unit 52, and the color filters 54 that transmit blue light and the color filters 54 that transmit cyan light are arranged in a checkered pattern on the lower right of the color filter unit 52.

In the example illustrated in the center of FIG. 16B, the color filters 54 that transmit green light are arranged in two rows and two columns on the upper right of the color filter unit 52, and the color filters 54 that transmit red light are arranged in two rows and two columns on the upper left of the color filter unit 52. Furthermore, the color filters 54 that transmit white light and the color filters 54 that transmit magenta light are arranged in a checkered pattern on the lower left of the color filter unit 52, and the color filters 54 that transmit blue light and the color filters 54 that transmit cyan light are arranged in a checkered pattern on the lower right of the color filter unit 52.

Further, in the color filter unit 52 illustrated on the right side of FIG. 16B, the color filters 54 that transmit white light in the example on the left side of FIG. 16B are replaced with the color filters 54 that transmit light having a wavelength of magenta light.

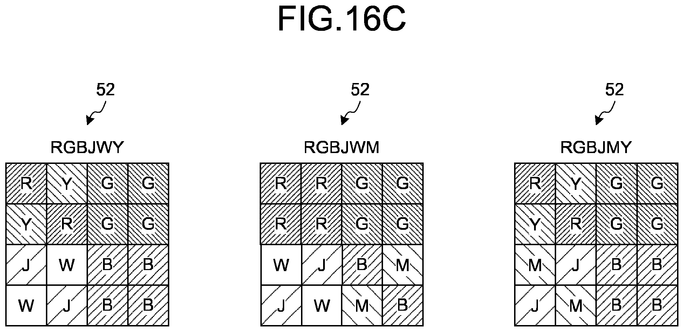

In the example illustrated on the left side of FIG. 16C, the color filters 54 that transmit green light are arranged in two rows and two columns on the upper right of the color filter unit 52, and the color filters 54 that transmit red light and the color filters 54 that transmit yellow light are arranged in a checkered pattern on the upper left of the color filter unit 52. Furthermore, the color filters 54 that transmit white light and the color filters 54 that transmit jade green light are arranged in a checkered pattern on the lower left of the color filter unit 52, and the color filters 54 that transmit blue light are arranged in two rows and two columns on the lower right of the color filter unit 52.

In the example illustrated in the center of FIG. 16C, the color filters 54 that transmit green light are arranged in two rows and two columns on the upper right of the color filter unit 52, and the color filters 54 that transmit red light are arranged in two rows and two columns on the upper left of the color filter unit 52. Furthermore, the color filters 54 that transmit white light and the color filters 54 that transmit jade green light are arranged in a checkered pattern on the lower left of the color filter unit 52, and the color filters 54 that transmit blue light and the color filters 54 that transmit magenta light are arranged in a checkered pattern on the lower right of the color filter unit 52.

Further, in the color filter unit 52 illustrated on the right side of FIG. 16C, the color filters 54 transmitting jade green light in the example on the left side of FIG. 16A are replaced with the color filters 54 transmitting magenta light, and the color filters 54 transmitting white light are replaced with the color filters 54 transmitting jade green light.

### <3.7 Modification 3>

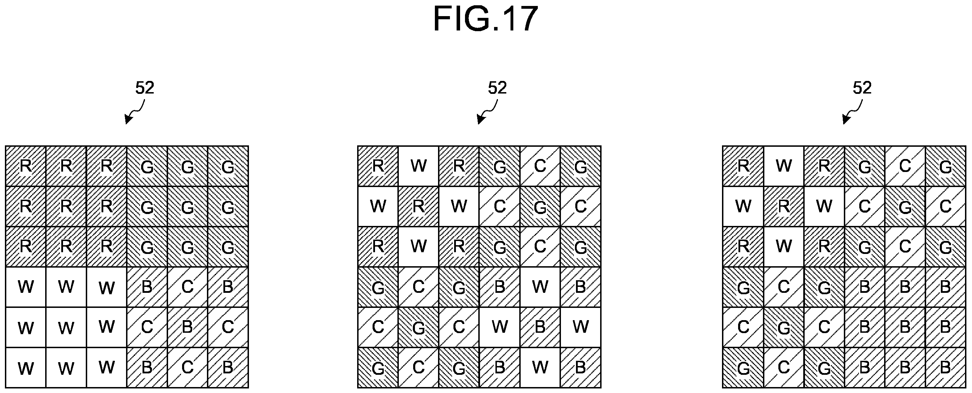

Furthermore, in the present disclosure, the color filter unit 52 may be configured by arranging the color filters 54 in six rows and six columns. Therefore, such a modification will be described with reference to FIG. 17. FIG. 17 is an explanatory diagram illustrating a planar configuration example of the color filter unit 52 according to Modification 3 of the present embodiment.

More specifically, in the example illustrated on the left side of FIG. 17, the color filters 54 that transmit green light are arranged in three rows and three columns on the upper right of the color filter unit 52, and the color filters 54 that transmit red light are arranged in three rows and three columns on the upper left of the color filter unit 52. Furthermore, the color filters 54 that transmit white light are arranged in three rows and three columns on the lower left of the color filter unit 52, and the color filters 54 that transmit blue light and the color filters 54 that transmit cyan light are arranged in a checkered pattern on the lower right of the color filter unit 52.

Further, in the example illustrated in the center of FIG. 17, the color filters 54 that transmit green light and the color filters 54 that transmit cyan light are arranged in a checkered pattern on the upper right and lower left of the color filter unit 52. Furthermore, the color filters 54 that transmit red light and the color filters 54 that transmit white light are arranged in a checkered pattern on the upper left of the color filter unit 52, and the color filters 54 that transmit blue light and the color filters 54 that transmit white light are arranged in a checkered pattern on the lower right of the color filter unit 52.

Further, in the color filter unit 52 illustrated on the right side of FIG. 17, a lower right region of the color filter unit 52 in the example in the center of FIG. 17 is replaced with the color filters 54 transmitting blue light and arranged in three rows and three columns.

### <3.8 Modification 4>

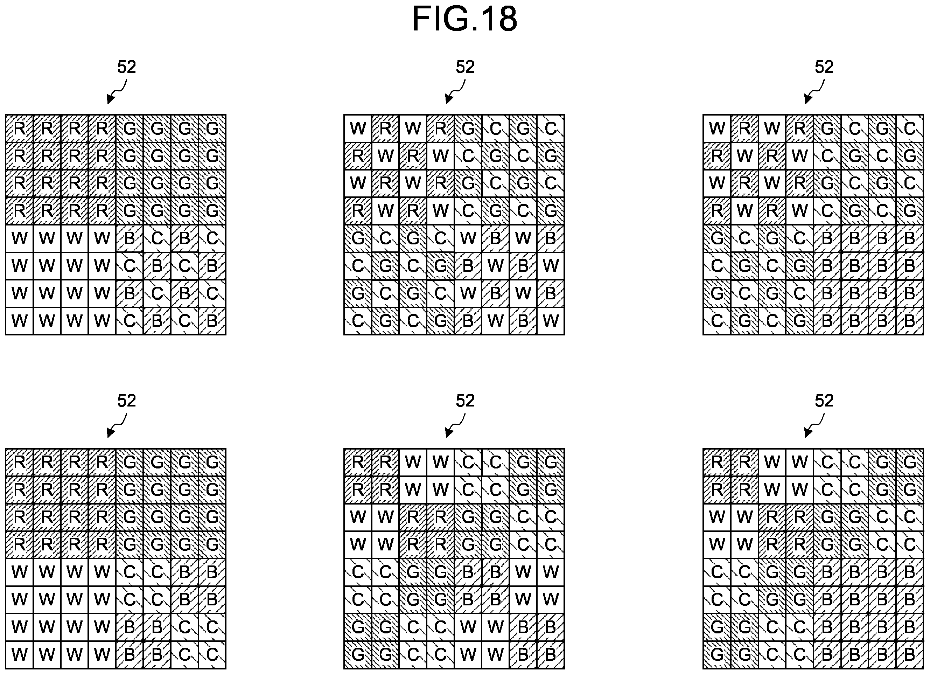

Furthermore, in the present disclosure, the color filter unit 52 may be configured by arranging the color filters 54 in eight rows and eight columns. Therefore, such a modification will be described with reference to FIG. 18. FIG. 18 is an explanatory diagram illustrating a planar configuration example of the color filter unit 52 according to Modification 3 of the present embodiment.

More specifically, in the example illustrated in an upper left part of FIG. 18, the color filters 54 that transmit green light are arranged in four rows and four columns on the upper right of the color filter unit 52, and the color filters 54 that transmit red light are arranged in four rows and four columns on the upper left of the color filter unit 52. Furthermore, the color filters 54 that transmit white light are arranged in four rows and four columns on the lower left of the color filter unit 52, and the color filters 54 that transmit blue light and the color filters 54 that transmit cyan light are arranged in a checkered pattern on the lower right of the color filter unit 52.

In the example illustrated in a lower left part of FIG. 18, the color filters 54 that transmit green light are arranged in four rows and four columns in the upper right of the color filter unit 52, and the color filters 54 that transmit red light are arranged in four rows and four columns in the upper left of the color filter unit 52. Furthermore, the color filters 54 that transmit white light are arranged in four rows and four columns on the lower left of the color filter unit 52. In addition, on the lower right of the color filter unit 52, four color filters 54 that transmit blue light arranged in two rows and two columns and four color filters 54 that transmit cyan light arranged in two rows and two columns are arranged in a checkered pattern.

In the example illustrated in an upper center part of FIG. 18, the color filters 54 that transmit green light and the color filters 54 that transmit cyan light are arranged in a checkered pattern on the upper right and lower left of the color filter unit 52. Further, on the upper left of the color filter unit 52, the color filters 54 that transmit red light and the color filters 54 that transmit white light are arranged in a checkered pattern. Furthermore, on the upper right of the color filter unit 52, the color filters 54 that transmit blue light and the color filters 54 that transmit white light are arranged in a checkered pattern.

In the example illustrated in a lower center part of FIG. 18, on the upper right and lower left of the color filter unit 52, four color filters 54 that transmit green light arranged in two rows and two columns and four color filters 54 that transmit cyan light arranged in two rows and two columns are arranged in a checkered pattern. In addition, on the upper left of the color filter unit 52, four color filters 54 that transmit red light arranged in two rows and two columns and four color filters 54 that transmit white light arranged in two rows and two columns are arranged in a checkered pattern. Furthermore, on the upper right of the color filter unit 52, four color filters 54 that transmit blue light arranged in two rows and two columns and four color filters 54 that transmit white light arranged in two rows and two columns are arranged in a checkered pattern.

Further, in the example illustrated in an upper right part of FIG. 18, a lower right region of the color filter unit 52 in the example in the upper center part of FIG. 18 is replaced with the color filters 54 transmitting blue light and arranged in four rows and four columns.

Further, in the example illustrated in a lower right part of FIG. 18, a lower right region of the color filter unit 52 in the example in the lower center part of FIG. 18 is replaced with the color filters 54 transmitting blue light and arranged in four rows and four columns.

### <3.9 Modification 5>

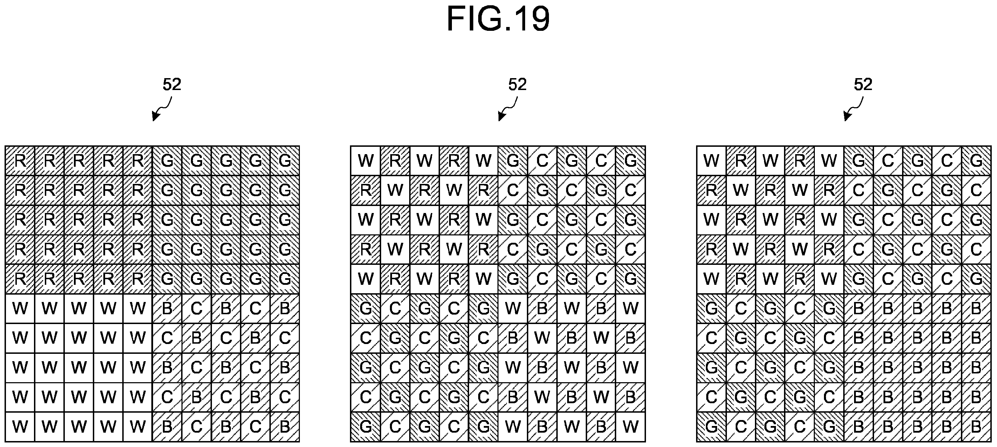

Further, in the embodiment of the present disclosure, the color filter unit 52 may be configured by arranging the color filters 54 in ten rows and ten columns. Therefore, such a modification will be described with reference to FIG. 19. FIG. 19 is an explanatory diagram illustrating a planar configuration example of the color filter unit 52 according to Modification 3 of the present embodiment.

More specifically, in the example illustrated on the left side of FIG. 19, the color filters 54 that transmit green light are arranged in five rows and five columns on the upper right of the color filter unit 52, and the color filters 54 that transmit red light are arranged in five rows and five columns on the upper left of the color filter unit 52. Furthermore, the color filters 54 that transmit white light are arranged in five rows and five columns on the lower left of the color filter unit 52, and the color filters 54 that transmit blue light and the color filters 54 that transmit cyan light are arranged in a checkered pattern on the lower right of the color filter unit 52.

In the example illustrated in the center of FIG. 19, the color filters 54 that transmit green light and the color filters 54 that transmit cyan light are arranged in a checkered pattern on the upper right and lower left of the color filter unit 52. Further, on the upper left of the color filter unit 52, the color filters 54 that transmit white light and the color filters 54 that transmit red light are arranged in a checkered pattern. Furthermore, on the upper right of the color filter unit 52, the color filters 54 that transmit white light and the color filters 54 that transmit blue light are arranged in a checkered pattern.

Further, in the example illustrated on the right side of FIG. 19, a lower right region of the color filter unit 52 in the example in the lower center part of FIG. 19 is replaced with the color filters 54 transmitting blue light and arranged in five rows and five columns.

Note that, as described above, in the embodiments of the present disclosure, the number of color filters 54 arranged in the color filter unit 52 is not limited to the numbers illustrated so far, and various numbers can be selected.

### <<4. Summary>>

As described above, according to the embodiments of the present disclosure, the effects of improving color reproducibility and suppressing noise can be obtained by arranging the color filters 54 in consideration of the refractive index level relationship between the adjacent color filters 54.

Furthermore, the imaging device 1 according to the embodiments of the present disclosure can be manufactured by using a method, a device, and conditions used for manufacturing a general semiconductor device. That is, the imaging device 1 according to the present embodiments can be manufactured using an existing semiconductor device manufacturing process.

Note that examples of the above-described method include a physical vapor deposition (PVD) method, a chemical vapor deposition (CVD) method, and an atomic layer deposition (ALD) method. Examples of the PVD method include a vacuum vapor deposition method, an electron beam (EB) vapor deposition method, various sputtering methods (a magnetron sputtering method, a radio frequency (RF)-direct current (DC) coupled bias sputtering method, an electron cyclotron resonance (ECR) sputtering method, a counter target sputtering method, a high frequency sputtering method, and the like), an ion plating method, a laser ablation method, a molecular beam epitaxy (MBE) method, and a laser transfer method. Further, examples of the CVD method include a plasma CVD method, a thermal CVD method, an organic metal (MO) CVD method, and a photo CVD method. Further, other methods include an electrolytic plating method or an electroless plating method, a spin coating method; an immersion method; a cast method; a micro-contact print method; a drop cast method; various printing methods such as a screen printing method, an inkjet printing method, an offset printing method, a gravure printing method, and a flexographic printing method; a stamping method; a spray method; and various coating methods such as an air doctor coater method, a blade coater method, a rod coater method, a knife coater method, a squeeze coater method, a reverse roll coater method, a transfer roll coater method, a gravure coater method, a kiss coater method, a cast coater method, a spray coater method, a slit orifice coater method, and a calendar coater method. Furthermore, examples of a patterning method include chemical etching such as a shadow mask, laser transfer, and photolithography, and physical etching using ultraviolet rays, laser, or the like. In addition, examples of planarization technique include a chemical mechanical polishing (CMP) method, a laser planarization method, a reflow method, and the like.

### <<5. Application examples>>

### <5.1 Application example to camera>

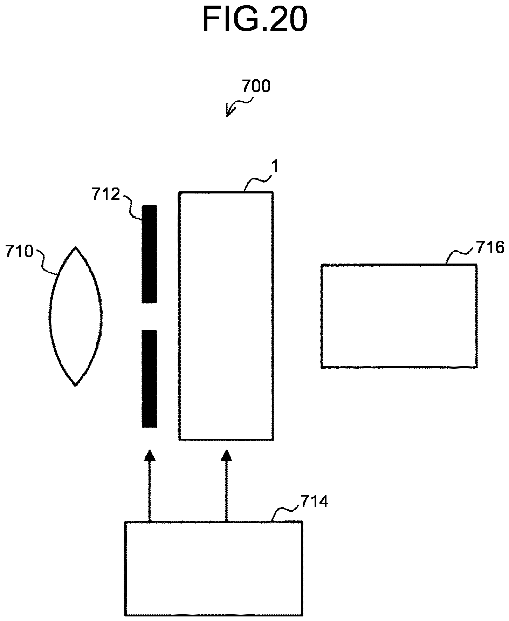

Technology according to the present disclosure (present technology) can be further applied to various products. For example, the technology according to the present disclosure may be applied to a camera or the like. Therefore, a configuration example of a camera 700 as an electronic device to which the present technology is applied will be described with reference to FIG. 20. FIG. 20 is an explanatory diagram illustrating an example of a schematic functional configuration of the camera 700 to which the technology according to the present disclosure (present technology) can be applied.

As illustrated in FIG. 20, the camera 700 includes the imaging device 1, an optical lens 710, a shutter mechanism 712, a drive circuit unit 714, and a signal processing circuit unit 716. The optical lens 710 forms an image of image light (incident light) from a subject on an imaging surface of the imaging device 1. As a result, signal charges are accumulated in the imaging element 100 of the imaging device 1 for a certain period. The shutter mechanism 712 opens and closes to control a light irradiation period and a light shielding period for the imaging device 1. The drive circuit unit 714 supplies a drive signal for controlling a signal transfer operation of the imaging device 1, a shutter operation of the shutter mechanism 712, and the like to the imaging device and the shutter mechanism. That is, the imaging device 1 performs signal transfer on the basis of the drive signal (timing signal) supplied from the drive circuit unit 714. The signal processing circuit unit 716 performs various types of signal processing. For example, the signal processing circuit unit 716 outputs a video signal subjected to the signal processing to, for example, a storage medium (not illustrated) such as a memory, or to a display unit (not illustrated).

The configuration example of the camera 700 has been described above. Each of the above-described components may be configured using a general-purpose member, or may be configured by hardware specialized for a function of each component. Such a configuration can be appropriately changed according to a technical level at the time of implementation.

### <5.2 Application example to smartphone>

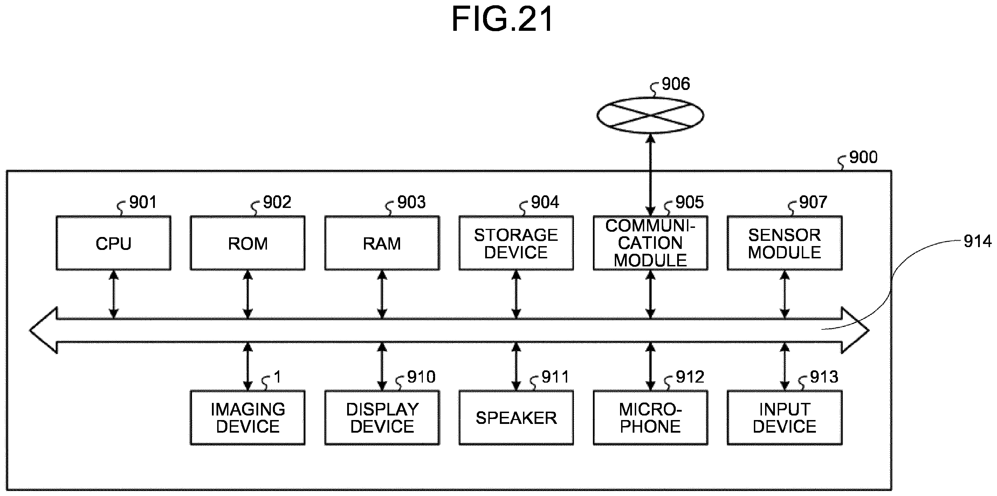

For example, the technology according to the present disclosure may be applied to a smartphone or the like. Therefore, a configuration example of a smartphone 900 as an electronic device to which the present technology is applied will be described with reference to FIG. 21. FIG. 21 is a block diagram illustrating an example of a schematic functional configuration of the smartphone 900 to which the technology according to the present disclosure (the present technology) can be applied.

As illustrated in FIG. 21, the smartphone 900 includes a central processing unit (CPU) 901, a read only memory (ROM) 902, and a random access memory (RAM) 903. In addition, the smartphone 900 includes a storage device 904, a communication module 905, and a sensor module 907. Furthermore, the smartphone 900 includes the imaging device 1, a display device 910, a speaker 911, a microphone 912, an input device 913, and a bus 914. Furthermore, the smartphone 900 may include a processing circuit such as a digital signal processor (DSP) instead of or in addition to the CPU 901.

The CPU 901 functions as an arithmetic processing device and a control device, and controls an overall operation in the smartphone 900 or a part thereof according to various programs recorded in the ROM 902, the RAM 903, the storage device 904, or the like. The ROM 902 stores programs, operation parameters, and the like used by the CPU 901. The RAM 903 primarily stores programs used in execution of the CPU 901, parameters that appropriately change in the execution, and the like. The CPU 901, the ROM 902, and the RAM 903 are connected to one another by the bus 914. In addition, the storage device 904 is a device for data storage configured as an example of a storage unit of the smartphone 900. The storage device 904 includes, for example, a magnetic storage device such as a hard disk drive (HDD), a semiconductor storage device, an optical storage device, and the like. The storage device 904 stores programs and various data executed by the CPU 901, various data acquired from the outside, and the like.

The communication module 905 is a communication interface including, for example, a communication device for connecting to a communication network 906. The communication module 905 can be, for example, a communication card for wired or wireless local area network (LAN), Bluetooth (registered trademark), wireless USB (WUSB), or the like. Furthermore, the communication module 905 may be a router for optical communication, a router for asymmetric digital subscriber line (ADSL), a modem for various types of communication, or the like. The communication module 905 transmits and receives signals and the like to and from the Internet and other communication devices using a predetermined protocol such as Transmission Control Protocol (TCP)/Internet Protocol (IP). Furthermore, the communication network 906 connected to the communication module 905 is a network connected in a wired or wireless manner, and is, for example, the Internet, a home LAN, infrared communication, satellite communication, or the like.

The sensor module 907 includes, for example, various sensors such as a motion sensor (for example, an acceleration sensor, a gyro sensor, a geomagnetic sensor, or the like), a biological information sensor (for example, a pulse sensor, a blood pressure sensor, a fingerprint sensor, or the like), or a position sensor (for example, a global navigation satellite system (GNSS) receiver or the like).

The imaging device 1 is provided on a surface of the smartphone 900, and can image an object or the like located on a back side or a front side of the smartphone 900. Specifically, the technology according to the present disclosure (present technology) can be applied to the imaging device 1. Furthermore, the imaging device 1 can further include an optical system mechanism (not illustrated) including an imaging lens, a zoom lens, a focus lens, and the like, and a drive system mechanism (not illustrated) that controls an operation of the optical system mechanism. Then, the above imaging element collects incident light from the object as an optical image, and the above signal processing circuit photoelectrically converts the formed optical image in units of pixels, reads a signal of each pixel as an imaging signal, and performs image processing to acquire a captured image.

The display device 910 is provided on the surface of the smartphone 900, and can be, for example, a display device such as a liquid crystal display (LCD) or an organic electro luminescence (EL) display. The display device 910 can display an operation screen, a captured image acquired by the above-described imaging device 1, and the like.

The speaker 911 can output, for example, a call voice, a voice accompanying video content displayed by the display device 910 described above, and the like to a user.

The microphone 912 can collect, for example, a call voice of a user, a voice including a command to activate a function of the smartphone 900, and a voice in a surrounding environment of the smartphone 900.

The input device 913 is a device operated by a user, such as a button, a keyboard, a touch panel, or a mouse. The input device 913 includes an input control circuit that generates an input signal on the basis of information input by the user and outputs the input signal to the CPU 901. By operating this input device 913, the user can input various data to the smartphone 900 and give an instruction on a processing operation.

The configuration example of the smartphone 900 has been described above. Each of the above-described components may be configured using a general-purpose member, or may be configured by hardware specialized for a function of each component. Such a configuration can be appropriately changed according to a technical level at the time of implementation.

### <5.3 Application example to microscope system>

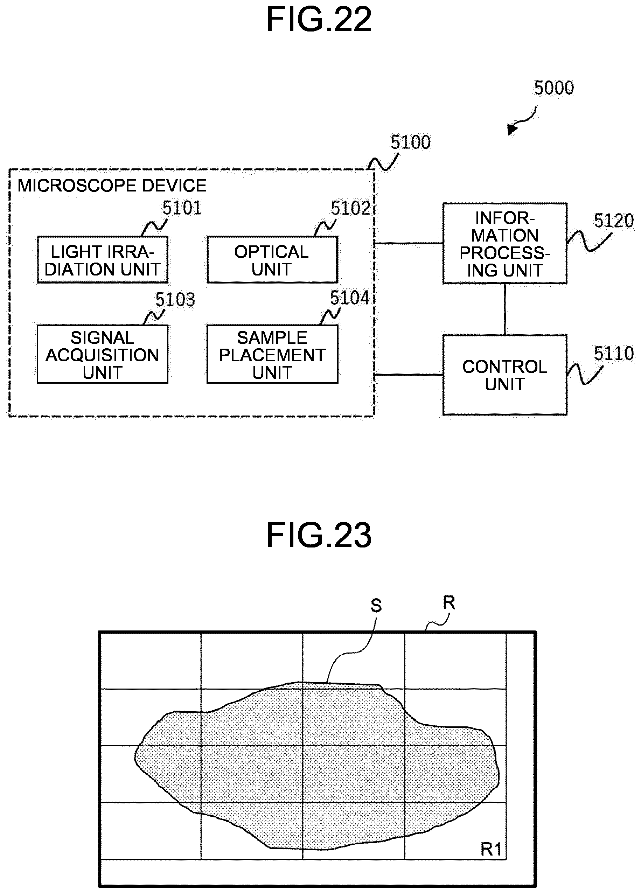

For example, the technology according to the present disclosure may be applied to a microscope system or the like. Therefore, a configuration example of a microscope system 5000 as an electronic device to which the present technology is applied will be described with reference to FIG. 22. FIG. 22 is a diagram schematically illustrating an overall configuration of the microscope system 5000.

A microscope system 5000 shown in FIG. 22 includes a microscope device 5100, a control unit 5110, and an information processing unit 5120. The microscope device 5100 includes a light irradiation unit 5101, an optical unit 5102, and a signal acquisition unit 5103. The microscope device 5100 may further include a sample placement unit 5104 on which a biological sample S is placed. Note that the configuration of the microscope device is not limited to that shown in FIG. 22. For example, the light irradiation unit 5101 may exist outside the microscope device 5100, and a light source not included in the microscope device 5100 may be used as the light irradiation unit 5101. Alternatively, the light irradiation unit 5101 may be disposed so that the sample placement unit 5104 is sandwiched between the light irradiation unit 5101 and the optical unit 5102, and may be disposed on the side at which the optical unit 5102 exists, for example. The microscope device 5100 may be designed to be capable of performing one or more of the following: bright-field observation, phase contrast observation, differential interference contrast observation, polarization observation, fluorescent observation, and darkfield observation.

The microscope system 5000 may be designed as a so-called whole slide imaging (WSI) system or a digital pathology imaging system, and can be used for pathological diagnosis. Alternatively, the microscope system 5000 may be designed as a fluorescence imaging system, or particularly, as a multiple fluorescence imaging system.

For example, the microscope system 5000 may be used to make an intraoperative pathological diagnosis or a telepathological diagnosis. In the intraoperative pathological diagnosis, the microscope device 5100 can acquire the data of the biological sample S acquired from the subject of the operation while the operation is being performed, and then transmit the data to the information processing unit 5120. In the telepathological diagnosis, the microscope device 5100 can transmit the acquired data of the biological sample S to the information processing unit 5120 located in a place away from the microscope device 5100 (such as in another room or building). In these diagnoses, the information processing unit 5120 then receives and outputs the data. On the basis of the output data, the user of the information processing unit 5120 can make a pathological diagnosis.

### (Biological Sample)

The biological sample S may be a sample containing a biological component. The biological component may be a tissue, a cell, a liquid component of the living body (blood, urine, or the like), a culture, or a living cell (a myocardial cell, a nerve cell, a fertilized egg, or the like). The biological sample may be a solid, or may be a specimen fixed with a fixing reagent such as paraffin or a solid formed by freezing. The biological sample can be a section of the solid. A specific example of the biological sample may be a section of a biopsy sample.

The biological sample may be one that has been subjected to a treatment such as staining or labeling. The treatment may be staining for indicating the morphology of the biological component or for indicating the substance (surface antigen or the like) contained in the biological component, and can be hematoxylin-eosin (HE) staining or immunohistochemistry staining, for example. The biological sample may be one that has been subjected to the above treatment with one or more reagents, and the reagent(s) can be a fluorescent dye, a coloring reagent, a fluorescent protein, or a fluorescence-labeled antibody.

The specimen may be prepared from a tissue sample for the purpose of pathological diagnosis or clinical examination. Alternatively, the specimen is not necessarily of the human body, and may be derived from an animal, a plant, or some other material. The specimen may differ in property, depending on the type of the tissue being used (such as an organ or a cell, for example), the type of the disease being examined, the attributes of the subject (such as age, gender, blood type, and race, for example), or the subject's daily habits (such as an eating habit, an exercise habit, and a smoking habit, for example). The specimen may be accompanied by identification information (bar code, QR code (registered trademark), or the like) for identifying each specimen, and be managed in accordance with the identification information.

### (Light Irradiation Unit)

The light irradiation unit 5101 is a light source for illuminating the biological sample S, and is an optical unit that guides light emitted from the light source to a specimen. The light source can illuminate a biological sample with visible light, ultraviolet light, infrared light, or a combination thereof. The light source may be one or more of the following: a halogen light source, a laser light source, an LED light source, a mercury light source, and a xenon light source. The light source in fluorescent observation may be of a plurality of types and/or wavelengths, and the types and the wavelengths may be appropriately selected by a person skilled in the art. The light irradiation unit may have a configuration of a transmissive type, a reflective type, or an epi-illumination type (a coaxial epi-illumination type or a side-illumination type).

### (Optical Unit)

The optical unit 5102 is designed to guide the light from the biological sample S to the signal acquisition unit 5103. The optical unit may be designed to enable the microscope device 5100 to observe or capture an image of the biological sample S. The optical unit 5102 may include an objective lens. The type of the objective lens may be appropriately selected by a person skilled in the art, in accordance with the observation method. The optical unit may also include a relay lens for relaying an image magnified by the objective lens to the signal acquisition unit. The optical unit may further include optical components other than the objective lens and the relay lens, and the optical components may be an eyepiece, a phase plate, a condenser lens, and the like. The optical unit 5102 may further include a wavelength separation unit designed to separate light having a predetermined wavelength from the light from the biological sample S. The wavelength separation unit may be designed to selectively cause light having a predetermined wavelength or a predetermined wavelength range to reach the signal acquisition unit. The wavelength separation unit may include one or more of the following: a filter, a polarizing plate, a prism (Wollaston prism), and a diffraction grating that selectively pass light, for example. The optical component(s) included in the wavelength separation unit may be disposed in the optical path from the objective lens to the signal acquisition unit, for example. The wavelength separation unit is provided in the microscope device in a case where fluorescent observation is performed, or particularly, where an excitation light irradiation unit is included. The wavelength separation unit may be designed to separate fluorescence or white light from fluorescence.

### (Signal Acquisition Unit)

The signal acquisition unit 5103 may be designed to receive light from the biological sample S, and convert the light into an electrical signal, or particularly, into a digital electrical signal. The signal acquisition unit may be designed to be capable of acquiring data about the biological sample S, on the basis of the electrical signal. The signal acquisition unit may be designed to be capable of acquiring data of an image (a captured image, or particularly, a still image, a time-lapse image, or a moving image) of the biological sample S, or particularly, may be designed to acquire data of an image enlarged by the optical unit. For example, the imaging device 1 according to the embodiment of the present disclosure can be applied to the signal acquisition unit including the plurality of imaging elements 100 arranged in a two-dimensional manner. Further, the signal acquisition unit may include an imaging element for acquiring a low-resolution image and an imaging element for acquiring a high-resolution image, or may include an imaging element for sensing for AF or the like and an imaging element for outputting an image for observation or the like. The imaging device 1 may include not only the plurality of imaging elements 100, but also a signal processing unit (including one or more of the following: a CPU, a DSP, and a memory) that performs signal processing using pixel signals from the respective imaging elements 100, and an output control unit that controls outputting of image data generated from the pixel signals and processed data generated by the signal processing unit. Such an imaging device 1 can be preferably configured as one semiconductor device. Note that the microscope system 5000 may further include an event detection sensor. The event detection sensor includes a pixel that photoelectrically converts incident light, and may be designed to detect that a change in the luminance of the pixel exceeds a predetermined threshold, and regard the change as an event. The event detection sensor may be of an asynchronous type.

### (Control Unit)

The control unit 5110 controls imaging being performed by the microscope device 5100. For the imaging control, the control unit can drive movement of the optical unit 5102 and/or the sample placement unit 5104, to adjust the positional relationship between the optical unit and the sample placement unit. The control unit 5110 can move the optical unit and/or the sample placement unit in a direction toward or away from each other (in the optical axis direction of the objective lens, for example). The control unit may also move the optical unit and/or the sample placement unit in any direction in a plane perpendicular to the optical axis direction. For the imaging control, the control unit may control the light irradiation unit 5101 and/or the signal acquisition unit 5103.

### (Sample Placement Unit)

The sample placement unit 5104 may be designed to be capable of securing the position of a biological sample on the sample placement unit, and may be a so-called stage. The sample placement unit 5104 may be designed to be capable of moving the position of the biological sample in the optical axis direction of the objective lens and/or in a direction perpendicular to the optical axis direction.

### (Information Processing Unit)

The information processing unit 5120 can acquire, from the microscope device 5100, data (imaging data or the like) acquired by the microscope device 5100. The information processing unit can perform image processing on the imaging data. The image processing may include an unmixing process, or more specifically, a spectral unmixing process. The unmixing process may include a process of extracting data of the optical component of a predetermined wavelength or in a predetermined wavelength range from the imaging data to generate image data, or a process of removing data of the optical component of a predetermined wavelength or in a predetermined wavelength range from the imaging data. The image processing may also include an autofluorescence separation process for separating the autofluorescence component and the dye component of a tissue section, and a fluorescence separation process for separating wavelengths between dyes having different fluorescence wavelengths from each other. The autofluorescence separation process may include a process of removing the autofluorescence component from image information about another specimen, using an autofluorescence signal extracted from one specimen of the plurality of specimens having the same or similar properties. The information processing unit 5120 may transmit data for the imaging control to the control unit 5110, and the control unit 5110 that has received the data may control the imaging being by the microscope device 5100 in accordance with the data.

The information processing unit 5120 may be designed as an information processing device such as a general-purpose computer, and may include a CPU, RAM, and ROM. The information processing unit may be included in the housing of the microscope device 5100, or may be located outside the housing. Further, the various processes or functions to be executed by the information processing unit may be realized by a server computer or a cloud connected via a network.

The method to be implemented by the microscope device 5100 to capture an image of the biological sample S may be appropriately selected by a person skilled in the art, in accordance with the type of the biological sample, the purpose of imaging, and the like. Examples of the imaging method are described below.

One example of the imaging method is as follows. The microscope device can first identify an imaging target region. The imaging target region may be identified so as to cover the entire region in which the biological sample exists, or may be identified so as to cover the target portion (the portion in which the target tissue section, the target cell, or the target lesion exists) of the biological sample. Next, the microscope device divides the imaging target region into a plurality of divided regions of a predetermined size, and the microscope device sequentially captures images of the respective divided regions. As a result, an image of each divided region is acquired. As shown in FIG. 23, the microscope device identifies an imaging target region R that covers the entire biological sample S. The microscope device then divides the imaging target region R into 16 divided regions. The microscope device then captures an image of a divided region R1, and next captures one of the regions included in the imaging target region R, such as an image of a region adjacent to the divided region R1. After that, divided region imaging is performed until images of all the divided regions have been captured. Note that an image of a region other than the imaging target region R may also be captured on the basis of captured image information about the divided regions. The positional relationship between the microscope device and the sample placement unit is adjusted so that an image of the next divided region is captured after one divided region is captured. The adjustment may be performed by moving the microscope device, moving the sample placement unit, or moving both. The signal acquisition unit may capture an image of each divided region via the optical unit. Further, images of the respective divided regions may be continuously captured while the microscope device and/or the sample placement unit is moved, or movement of the microscope device and/or the sample placement unit may be stopped every time an image of a divided region is captured. The imaging target region may be divided so that the respective divided regions partially overlap, or the imaging target region may be divided so that the respective divided regions do not overlap. A plurality of images of each divided region may be captured while the imaging conditions such as the focal length and/or the exposure time are changed. The information processing device can also generate image data of a wider region by stitching a plurality of adjacent divided regions. As the stitching process is performed on the entire imaging target region, an image of a wider region can be acquired with respect to the imaging target region. Also, image data with a lower resolution can be generated from the images of the divided regions or the images subjected to the stitching process.

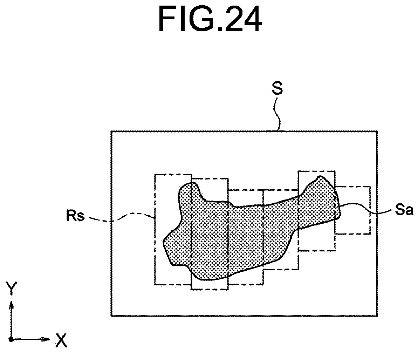

Another example of the imaging method is as follows. The microscope device can first identify an imaging target region. The imaging target region may be identified so as to cover the entire region in which the biological sample exists, or may be identified so as to cover the target portion (the portion in which the target tissue section or the target cell exists) of the biological sample. Next, the microscope device scans a region (also referred to as a "divided scan region") of the imaging target region in one direction (also referred to as a "scan direction") in a plane perpendicular to the optical axis, and thus captures an image. After the scanning of the divided scan region is completed, the divided scan region next to the scan region is then scanned. These scanning operations are repeated until an image of the entire imaging target region is captured. As shown in FIG. 24, the microscope device identifies a region (a gray portion) in which a tissue section of the biological sample S exists, as an imaging target region Sa. The microscope device then scans a divided scan region Rs of the imaging target region Sa in the Y-axis direction. After completing the scanning of the divided scan region Rs, the microscope device then scans the divided scan region that is the next in the X-axis direction. This operation is repeated until scanning of the entire imaging target region Sa is completed. For the scanning of each divided scan region, the positional relationship between the microscope device and the sample placement unit is adjusted so that an image of the next divided scan region is captured after an image of one divided scan region is captured. The adjustment may be performed by moving the microscope device, moving the sample placement unit, or moving both. The signal acquisition unit may capture an image of each divided region via a magnifying optical system. Also, images of the respective divided scan regions may be continuously captured while the microscope device and/or the sample placement unit is moved. The imaging target region may be divided so that the respective divided scan regions partially overlap, or the imaging target region may be divided so that the respective divided scan regions do not overlap. A plurality of images of each divided scan region may be captured while the imaging conditions such as the focal length and/or the exposure time are changed. The information processing device can also generate image data of a wider region by stitching a plurality of adjacent divided scan regions. As the stitching process is performed on the entire imaging target region, an image of a wider region can be acquired with respect to the imaging target region. Also, image data with a lower resolution can be generated from the images of the divided scan regions or the images subjected to the stitching process.

The configuration example of the microscope system 5000 has been described above. Each of the above-described components may be configured using a general-purpose member, or may be configured by hardware specialized for a function of each component. Such a configuration can be appropriately changed according to a technical level at the time of implementation.

### <<6. Supplement>>

Although the preferred embodiments of the present disclosure have been described in detail with reference to the accompanying drawings, the technical scope of the present disclosure is not limited to such examples. It is obvious that a person having ordinary knowledge in the technical field of the present disclosure can conceive various changes or modifications within the scope of the technical idea described in the claims, and it is naturally understood that these also belong to the technical scope of the present disclosure.

Furthermore, the effects described in the present specification are merely illustrative or exemplary, and are not restrictive. That is, the technology according to the present disclosure can exhibit other effects obvious to those skilled in the art from the description of the present specification together with or instead of the above effects.

Note that the present technology can also have the following configurations.
(1) An imaging device comprising a pixel array unit configured by two-dimensionally arranging unit regions each including a plurality of imaging elements, wherein
   each of the imaging elements includes
   a color filter that has a rectangular shape in plan view and transmits light having a wavelength in a predetermined wavelength band, and
   a photoelectric conversion unit that generates a charge by light incident through the color filter, and
   in the unit region,
   five or more types of the plurality of imaging elements distinguished by a wavelength of light transmitted through the corresponding color filter are arranged in m rows and n columns,
   at least a first imaging element including a first color filter that transmits red light, a second imaging element including a second color filter that transmits green light, and a third imaging element including a third color filter that transmits blue light are included, and
   the first imaging element and a fourth imaging element including a fourth color filter having a refractive index lower than a refractive index of the first color filter at a wavelength of 510 nm to 550 nm are not arranged so as to be in contact with each other on two or more sides of the first imaging element.
(2) The imaging device according to (1), wherein the refractive index of the fourth color filter is lower than the refractive index of the first color filter by 0.1 or more at the wavelength of 510 nm to 550 nm.
(3) The imaging device according to (1) or (2), wherein
   in the unit region,
   the second imaging element and a fifth imaging element including a fifth color filter having a refractive index higher than a refractive index of the second color filter at the wavelength of 510 nm to 550 nm are not arranged so as to be in contact with each other on two or more sides of the second imaging element.
(4) The imaging device according to (3), wherein the refractive index of the fifth color filter is higher than the refractive index of the second color filter by 0.1 or more at the wavelength of 510 nm to 550 nm.
(5) The imaging device according to any one of (1) to (4), wherein
   in the unit region,
   the second imaging element and a sixth imaging element including a sixth color filter having a refractive index lower than a refractive index of the second color filter at the wavelength of 510 nm to 550 nm are arranged so as to be in contact with each other.
(6) The imaging device according to (5), wherein the refractive index of the sixth color filter is lower than the refractive index of the second color filter by 0.1 or more at the wavelength of 510 nm to 550 nm.
(7) The imaging device according to any one of (1) to (6), wherein
   in the unit region,
   the third imaging element and a seventh imaging element including a seventh color filter having a refractive index higher than a refractive index of the third color filter at a wavelength of 440 nm to 480 nm are not arranged so as to be in contact with each other on two or more sides of the third imaging element.
(8) The imaging device according to (7), wherein the refractive index of the seventh color filter is higher than the refractive index of the third color filter by 0.1 or more at the wavelength of 440 nm to 480 nm.
(9) The imaging device according to any one of (1) to (8), wherein
   the unit region includes
   the imaging element including the color filter that transmits cyan light or the imaging element including the color filter that transmits jade green light.
(10) The imaging device according to any one of (1) to (8), wherein
   the unit region includes
   the imaging element including the color filter that transmits cyan light and the imaging element including the color filter that transmits jade green light.
(11) The imaging device according to any one of (1) to (10), wherein
   the unit region includes
   at least one of the imaging elements selected from a group consisting of the imaging element including the color filter that transmits white light, the imaging element including the color filter that transmits yellow light, and the imaging element including the color filter that transmits magenta light.
(12) The imaging device according to any one of (1) to (10), wherein
   the unit region includes
   at least two of the imaging elements selected from a group consisting of the imaging element including the color filter that transmits white light, the imaging element including the color filter that transmits yellow light, and the imaging element including the color filter that transmits magenta light.
(13) The imaging device according to any one of (1) to (12), wherein
   the unit region is configured by arranging the plurality of imaging elements in four rows and four columns.
(14) The imaging device according to any one of (1) to (12), wherein
   the unit region is configured by arranging the plurality of imaging elements in six rows and six columns.
(15) The imaging device according to any one of (1) to (12), wherein
   the unit region is configured by arranging the plurality of imaging elements in eight rows and eight columns.
(16) An electronic device on which an imaging device is mounted, wherein
   the imaging device includes
   a pixel array unit configured by two-dimensionally arranging unit regions each including a plurality of imaging elements,
   each of the imaging elements includes
   a color filter that has a rectangular shape in plan view and transmits light having a wavelength in a predetermined wavelength band, and
   a photoelectric conversion unit that generates a charge by light incident through the color filter, and
   in the unit region,
   five or more types of the plurality of imaging elements distinguished by a wavelength of light transmitted through the corresponding color filter are arranged in m rows and n columns,
   at least a first imaging element including a first color filter that transmits red light, a second imaging element including a second color filter that transmits green light, and a third imaging element including a third color filter that transmits blue light are included, and
   the first imaging element and a fourth imaging element including a fourth color filter having a refractive index lower than a refractive index of the first color filter at a wavelength of 510 nm to 550 nm are not arranged so as to be in contact with each other on two or more sides of the first imaging element.

### Reference Signs List

- 1: IMAGING DEVICE
- 10: SEMICONDUCTOR SUBSTRATE
- 10a: FRONT SURFACE
- 10b: LIGHT RECEIVING SURFACE
- 12: PHOTOELECTRIC CONVERSION UNIT
- 14: ELEMENT SEPARATION WALL
- 20: WIRING LAYER
- 22: WIRING LINE
- 24: INSULATING FILM
- 30: PIXEL ARRAY UNIT
- 32: VERTICAL DRIVE CIRCUIT UNIT
- 34: COLUMN SIGNAL PROCESSING CIRCUIT UNIT
- 36: HORIZONTAL DRIVE CIRCUIT UNIT
- 38: OUTPUT CIRCUIT UNIT
- 40: CONTROL CIRCUIT UNIT
- 42: PIXEL DRIVE WIRING LINE
- 44: VERTICAL SIGNAL LINE
- 46: HORIZONTAL SIGNAL LINE
- 48: INPUT/OUTPUT TERMINAL
- 50: COLOR FILTER ARRAY
- 52: COLOR FILTER UNIT
- 54: COLOR FILTER
- 56: LIGHT SHIELDING PORTION
- 58: ON-CHIP LENS
- 100: IMAGING ELEMENT
- 700: CAMERA
- 710: OPTICAL LENS
- 712: SHUTTER MECHANISM
- 714: DRIVE CIRCUIT UNIT
- 716: SIGNAL PROCESSING CIRCUIT UNIT
- 900: SMARTPHONE
- 901: CPU
- 902: ROM
- 903: RAM
- 904: STORAGE DEVICE
- 905: COMMUNICATION MODULE
- 906: COMMUNICATION NETWORK
- 907: SENSOR MODULE
- 910: DISPLAY DEVICE
- 911: SPEAKER
- 912: MICROPHONE
- 913: INPUT DEVICE
- 914: BUS

## Claims

1. An imaging device comprising a pixel array unit configured by two-dimensionally arranging unit regions each including a plurality of imaging elements, wherein
each of the imaging elements includes
a color filter that has a rectangular shape in plan view and transmits light having a wavelength in a predetermined wavelength band, and
a photoelectric conversion unit that generates a charge by light incident through the color filter, and
in the unit region,
five or more types of the plurality of imaging elements distinguished by a wavelength of light transmitted through the corresponding color filter are arranged in m rows and n columns,
at least a first imaging element including a first color filter that transmits red light, a second imaging element including a second color filter that transmits green light, and a third imaging element including a third color filter that transmits blue light are included, and
the first imaging element and a fourth imaging element including a fourth color filter having a refractive index lower than a refractive index of the first color filter at a wavelength of 510 nm to 550 nm are not arranged so as to be in contact with each other on two or more sides of the first imaging element.

2. The imaging device according to claim 1, wherein the refractive index of the fourth color filter is lower than the refractive index of the first color filter by 0.1 or more at the wavelength of 510 nm to 550 nm.

3. The imaging device according to claim 1, wherein
in the unit region,
the second imaging element and a fifth imaging element including a fifth color filter having a refractive index higher than a refractive index of the second color filter at the wavelength of 510 nm to 550 nm are not arranged so as to be in contact with each other on two or more sides of the second imaging element.

4. The imaging device according to claim 3, wherein the refractive index of the fifth color filter is higher than the refractive index of the second color filter by 0.1 or more at the wavelength of 510 nm to 550 nm.

5. The imaging device according to claim 1, wherein
in the unit region,
the second imaging element and a sixth imaging element including a sixth color filter having a refractive index lower than a refractive index of the second color filter at the wavelength of 510 nm to 550 nm are arranged so as to be in contact with each other.

6. The imaging device according to claim 5, wherein the refractive index of the sixth color filter is lower than the refractive index of the second color filter by 0.1 or more at the wavelength of 510 nm to 550 nm.

7. The imaging device according to claim 1, wherein
in the unit region,
the third imaging element and a seventh imaging element including a seventh color filter having a refractive index higher than a refractive index of the third color filter at a wavelength of 440 nm to 480 nm are not arranged so as to be in contact with each other on two or more sides of the third imaging element.

8. The imaging device according to claim 7, wherein the refractive index of the seventh color filter is higher than the refractive index of the third color filter by 0.1 or more at the wavelength of 440 nm to 480 nm.

9. The imaging device according to claim 1, wherein
the unit region includes
the imaging element including the color filter that transmits cyan light or the imaging element including the color filter that transmits jade green light.

10. The imaging device according to claim 1, wherein
the unit region includes
the imaging element including the color filter that transmits cyan light and the imaging element including the color filter that transmits jade green light.

11. The imaging device according to claim 1, wherein
the unit region includes
at least one of the imaging elements selected from a group consisting of the imaging element including the color filter that transmits white light, the imaging element including the color filter that transmits yellow light, and the imaging element including the color filter that transmits magenta light.

12. The imaging device according to claim 1, wherein
the unit region includes
at least two of the imaging elements selected from a group consisting of the imaging element including the color filter that transmits white light, the imaging element including the color filter that transmits yellow light, and the imaging element including the color filter that transmits magenta light.

13. The imaging device according to claim 1, wherein
the unit region is configured by arranging the plurality of imaging elements in four rows and four columns.

14. The imaging device according to claim 1, wherein
the unit region is configured by arranging the plurality of imaging elements in six rows and six columns.

15. The imaging device according to claim 1, wherein
the unit region is configured by arranging the plurality of imaging elements in eight rows and eight columns.

16. An electronic device on which an imaging device is mounted, wherein
the imaging device includes
a pixel array unit configured by two-dimensionally arranging unit regions each including a plurality of imaging elements,
each of the imaging elements includes
a color filter that has a rectangular shape in plan view and transmits light having a wavelength in a predetermined wavelength band, and
a photoelectric conversion unit that generates a charge by light incident through the color filter, and
in the unit region,
five or more types of the plurality of imaging elements distinguished by a wavelength of light transmitted through the corresponding color filter are arranged in m rows and n columns,
at least a first imaging element including a first color filter that transmits red light, a second imaging element including a second color filter that transmits green light, and a third imaging element including a third color filter that transmits blue light are included, and
the first imaging element and a fourth imaging element including a fourth color filter having a refractive index lower than a refractive index of the first color filter at a wavelength of 510 nm to 550 nm are not arranged so as to be in contact with each other on two or more sides of the first imaging element.
